# EUROPEAN PATENT APPLICATION

(11) **EP 2 719 449 A1**
(43) Date of publication of application: **16.04.2014**
(21) Application number: 13192675.0
(22) Date of filing: 01.05.2012
(51) Int. Cl.: B01F 13/00, B01L 3/00

(54) **Molecular diagnostics platform that uses digital microfluidics and multiplexed bead detection**

(30) Priority: 02.05.2011 US 201161481508 P
(62) Divisional of application: 12779928.6
(71) Applicant: Advanced Liquid Logic, Inc., Research Triangle Park NC 27709 (US)
(72) Inventor: Bort, Donovan, Apex, NC North Carolina 27502 (US); Graham, Carrie, Raleigh, NC North Carolina 27614 (US); Pamula, Vamsee, Durham, NC North Carolina 27703 (US); Pollack, Michael, Durham, NC North Carolina 27707 (US); Sista, Ramakrishna, Morrisville, NC North Carolina 27560 (US); Srinivasan, Vijay, Durham, NC North Carolina 27701 (US)
(74) Representative: Cooper, John

(57) **Abstract**

A droplet actuator (110) comprising: one or more substrates (114, 116) arranged to form a droplet operations gap, the droplet operations gap comprising a region of gap height transition in which the gap height of the droplet operations gap transitions from a first gap height to a second gap height; and electrodes associated with the one or more substrates arranged for conducting droplet operations, the electrodes comprising a transition electrode which traverses the region of gap height transition. The electrodes may comprise electrowetting electrodes. The transition electrode may be flanked by first and second sets of electrodes having first and second footprint areas. The first footprint area may be greater than the second footprint area. The first set of electrodes may be arranged in a region of greater gap height and the second set of electrodes may be arranged in the region of lesser gap height.

## Description

### 1 Grant Information

This invention was made with government support under AI065169 awarded by the National Institutes of Health. The United States Government has certain rights in the invention.

### 2 Related Applications

This patent application is related to and claims priority to U.S. Provisional Patent Application No. 61/481,508, filed on May 2, 2011, entitled "Molecular Diagnostics Platform that uses Digital Microfluidics and Multiplexed Bead Detection," the entire disclosure of which are incorporated herein by reference.

### 3 Background

A droplet actuator typically includes one or more substrates configured to form a surface or gap for conducting droplet operations. The one or more substrates establish a droplet operations surface or gap for conducting droplet operations and may also include electrodes arrange to conduct the droplet operations. The droplet operations substrate or the gap between the substrates may be coated or filled with a filler fluid that is immiscible with the liquid that forms the droplets.

Droplet actuators are used in a variety of applications, including molecular diagnostic assays, such as nucleic acid based assays and immunoassays. In one example, nucleic acid based tests, such as reverse transcriptase polymerase chain reaction (RT-PCR) assays, are used for identification of respiratory viruses. Because a single sample may include multiple analytes to be evaluated, there is a need for improved approaches for multiplexing molecular diagnostic assays on a droplet actuator.

### 4 Definitions

As used herein, the following terms have the meanings indicated.

"Activate," with reference to one or more electrodes, means effecting a change in the electrical state of the one or more electrodes which, in the presence of a droplet, results in a droplet operation.

"Bead," with respect to beads on a droplet actuator, means any bead or particle that is capable of interacting with a droplet on or in proximity with a droplet actuator. Beads may be any of a wide variety of shapes, such as spherical, generally spherical, egg shaped, disc shaped, cubical and other three dimensional shapes. The bead may, for example, be capable of being transported in a droplet on a droplet actuator or otherwise configured with respect to a droplet actuator in a manner which permits a droplet on the droplet actuator to be brought into contact with the bead, on the droplet actuator and/or off the droplet actuator. Beads may be manufactured using a wide variety of materials, including for example, resins, and polymers. The beads may be any suitable size, including for example, microbeads, microparticles, nanobeads and nanoparticles. In some cases, beads are magnetically responsive; in other cases beads are not significantly magnetically responsive. For magnetically responsive beads, the magnetically responsive material may constitute substantially all of a bead or one component only of a bead. The remainder of the bead may include, among other things, polymeric material, coatings, and moieties which permit attachment of an assay reagent. Examples of suitable magnetically responsive beads include flow cytometry microbeads, polystyrene microparticles and nanoparticles, functionalized polystyrene microparticles and nanoparticles, coated polystyrene microparticles and nanoparticles, silica microbeads, fluorescent microspheres and nanospheres, functionalized fluorescent microspheres and nanospheres, coated fluorescent microspheres and nanospheres, color dyed microparticles and nanoparticles, magnetic microparticles and nanoparticles, superparamagnetic microparticles and nanoparticles (e.g., DYNABEADS® particles, available from Invitrogen Corp., Carlsbad, CA), fluorescent microparticles and nanoparticles, coated magnetic microparticles and nanoparticles, ferromagnetic microparticles and nanoparticles, coated ferromagnetic microparticles and nanoparticles, and those described in U.S. Patent Publication Nos. 20050260686, entitled "Multiplex flow assays preferably with magnetic particles as solid phase," published on November 24, 2005; 20030132538, entitled "Encapsulation of discrete quanta of fluorescent particles," published on July 17, 2003; 20050118574, entitled "Multiplexed Analysis of Clinical Specimens Apparatus and Method," published on June 2, 2005; 20050277197. Entitled "Microparticles with Multiple Fluorescent Signals and Methods of Using Same," published on December 15, 2005; 20060159962, entitled "Magnetic Microspheres for use in Fluorescence-based Applications," published on July 20, 2006; the entire disclosures of which are incorporated herein by reference for their teaching concerning beads and magnetically responsive materials and beads. Beads may be pre-coupled with a biomolecule (ligand). The ligand may, for example, be an antibody, protein or antigen, DNA/RNA probe or any other molecule with an affinity for the desired target. Examples of droplet actuator techniques for immobilizing magnetically responsive beads and/or non-magnetically responsive beads and/or conducting droplet operations protocols using beads are described in U.S. Patent Application No. 11/639,566, entitled "Droplet-Based Particle Sorting," filed on December 15, 2006; U.S. Patent Application No. 61/039,183, entitled "Multiplexing Bead Detection in a Single Droplet," filed on March 25, 2008; U.S. Patent Application No. 61/047,789, entitled "Droplet Actuator Devices and Droplet Operations Using Beads," filed on April 25, 2008; U.S. Patent Application No. 61/086,183, entitled "Droplet Actuator Devices and Methods for Manipulating Beads," filed on August 5, 2008; International Patent Application No. PCT/US2008/053545, entitled "Droplet Actuator Devices and Methods Employing Magnetic Beads," filed on February 11, 2008; International Patent Application No. PCT/US2008/058018, entitled "Bead-based Multiplexed Analytical Methods and Instrumentation," filed on March 24, 2008; International Patent Application No. PCT/US2008/058047, "Bead Sorting on a Droplet Actuator," filed on March 23, 2008; and International Patent Application No. PCT/US2006/047486, entitled "Droplet-based Biochemistry," filed on December 11, 2006; the entire disclosures of which are incorporated herein by reference. Bead characteristics may be employed in the multiplexing aspects of the invention. Examples of beads having characteristics suitable for multiplexing, as well as methods of detecting and analyzing signals emitted from such beads, may be found in U.S. Patent Publication No. 20080305481, entitled "Systems and Methods for Multiplex Analysis of PCR in Real Time," published on December 11, 2008; U.S. Patent Publication No. 20080151240, "Methods and Systems for Dynamic Range Expansion," published on June 26, 2008; U.S. Patent Publication No. 20070207513, entitled "Methods, Products, and Kits for Identifying an Analyte in a Sample," published on September 6, 2007; U.S. Patent Publication No. 20070064990, entitled "Methods and Systems for Image Data Processing," published on March 22, 2007; U.S. Patent Publication No. 20060159962, entitled "Magnetic Microspheres for use in Fluorescence-based Applications," published on July 20, 2006; U.S. Patent Publication No. 20050277197, entitled "Microparticles with Multiple Fluorescent Signals and Methods of Using Same," published on December 15, 2005; and U.S. Patent Publication No. 20050118574, entitled "Multiplexed Analysis of Clinical Specimens Apparatus and Method," published on June 2, 2005.

"Droplet" means a volume of liquid on a droplet actuator. Typically, a droplet is at least partially bounded by filler fluid. For example, a droplet may be completely surrounded by filler fluid or may be bounded by filler fluid and one or more surfaces of the droplet actuator. As another example, a droplet may be bounded by filler fluid, one or more surfaces of the droplet actuator, and the atmosphere. As yet another example, a droplet may be bounded by filler fluid and the atmosphere. Droplets may, for example, be aqueous or non-aqueous or may be mixtures or emulsions including aqueous and non-aqueous components. Droplets may take a wide variety of shapes; nonlimiting examples include generally disc shaped, slug shaped, truncated sphere, ellipsoid, spherical, partially compressed sphere, hemispherical, ovoid, cylindrical, combinations of such shapes, and various shapes formed during droplet operations, such as merging or splitting or formed as a result of contact of such shapes with one or more surfaces of a droplet actuator. For examples of droplet fluids that may be subjected to droplet operations using the approach of the invention, see International Patent Application No. PCT/US 06/47486, entitled, "Droplet-Based Biochemistry," filed on December 11, 2006. In various embodiments, a droplet may include a biological sample, such as whole blood, lymphatic fluid, serum, plasma, sweat, tear, saliva, sputum, cerebrospinal fluid, amniotic fluid, seminal fluid, vaginal excretion, serous fluid, synovial fluid, pericardial fluid, peritoneal fluid, pleural fluid, transudates, exudates, cystic fluid, bile, urine, gastric fluid, intestinal fluid, fecal samples, liquids containing single or multiple cells, liquids containing organelles, fluidized tissues, fluidized organisms, liquids containing multi-celled organisms, biological swabs and biological washes. Moreover, a droplet may include a reagent, such as water, deionized water, saline solutions, acidic solutions, basic solutions, detergent solutions and/or buffers. Other examples of droplet contents include reagents, such as a reagent for a biochemical protocol, such as a nucleic acid amplification protocol, an affinity-based assay protocol, an enzymatic assay protocol, a sequencing protocol, and/or a protocol for analyses of biological fluids.
"Droplet Actuator" means a device for manipulating droplets. For examples of droplet actuators, see Pamula et al., U.S. Patent 6,911,132, entitled "Apparatus for Manipulating Droplets by Electrowetting-Based Techniques," issued on June 28, 2005; Pamula et al., U.S. Patent Application No. 11/343,284, entitled "Apparatuses and Methods for Manipulating Droplets on a Printed Circuit Board," filed on filed on January 30, 2006; Pollack et al., International Patent Application No. PCT/US2006/047486, entitled "Droplet-Based Biochemistry," filed on December 11, 2006; Shenderov, U.S. Patents 6,773,566, entitled "Electrostatic Actuators for Microfluidics and Methods for Using Same," issued on August 10, 2004 and 6,565,727, entitled "Actuators for Microfluidics Without Moving Parts," issued on January 24, 2000; Kim et al., U.S. Patent Application Nos. 10/343,261, entitled "Electrowetting-driven Micropumping," filed on January 27, 2003; 11/275,668, entitled "Method and Apparatus for Promoting the Complete Transfer of Liquid Drops from a Nozzle," filed on January 23, 2006; 11/460,188, entitled "Small Object Moving on Printed Circuit Board," filed on January 23, 2006, 12/465,935, entitled "Method for Using Magnetic Particles in Droplet Microfluidics," filed on May 14, 2009; 12/513,157, entitled "Method and apparatus for real-time feedback control of electrical manipulation of droplets on chip," filed on April 30, 2009; Velev, U.S. Patent 7,547,380, entitled "Droplet Transportation Devices and Methods Having a Fluid Surface," issued on June 16, 2009; Sterling et al., U.S. Patent 7,163,612, entitled "Method, Apparatus and Article for Microfluidic Control via Electrowetting, for Chemical, Biochemical and Biological Assays and the Like," issued on January 16, 2007; Becker and Gascoyne et al., U.S. Patent Nos. 7,641,779, entitled "Method and Apparatus for Programmable fluidic Processing," issued on January 5, 2010, and 6,977,033, entitled "Method and Apparatus for Programmable fluidic Processing," issued on December 20, 2005; Decre et al., U.S. Patent 7,328,979, entitled "System for Manipulation of a Body of Fluid," issued on February 12, 2008; Yamakawa et al., U.S. Patent Pub. No. 20060039823, entitled "Chemical Analysis Apparatus," published on February 23, 2006; Wu, International Patent Pub. No. WO/2009/003184, entitled "Digital Microfluidics Based Apparatus for Heat-exchanging Chemical Processes," published on December 31, 2008; Fouillet et al., U.S. Patent Pub. No. 20090192044, entitled "Electrode Addressing Method," published on July 30, 2009; Fouillet et al., U.S. Patent 7,052,244, entitled "Device for Displacement of Small Liquid Volumes Along a Micro-catenary Line by Electrostatic Forces," issued on May 30, 2006; Marchand et al., U.S. Patent Pub. No. 20080124252, entitled "Droplet Microreactor," published on May 29, 2008; Adachi et al., U.S. Patent Pub. No. 20090321262, entitled "Liquid Transfer Device," published on December 31, 2009; Roux et al., U.S. Patent Pub. No. 20050179746, entitled "Device for Controlling the Displacement of a Drop Between two or Several Solid Substrates," published on August 18, 2005; Dhindsa et al., "Virtual Electrowetting Channels: Electronic Liquid Transport with Continuous Channel Functionality," Lab Chip, 10:832-836 (2010); the disclosures of which are incorporated herein by reference, along with their priority documents. Certain droplet actuators will include a base substrate, droplet operations electrodes associated with the substrate, one or more dielectric and/or hydrophobic layers atop the substrate and/or electrodes forming a droplet operations surface, and optionally, a top substrate separated from the droplet operations surface by a gap. The base and top substrates may in some cases be formed as one integral component. One or more reference electrodes may be provided on the top and/or bottom substrates and/or in the gap. In various embodiments, the manipulation of droplets by a droplet actuator may be electrode mediated, e.g., electrowetting mediated or dielectrophoresis mediated or Coulombic force mediated. Examples of other methods of controlling fluid flow that may be used in the droplet actuators of the invention include devices that induce hydrodynamic fluidic pressure, such as those that operate on the basis of mechanical principles (e.g. external syringe pumps, pneumatic membrane pumps, vibrating membrane pumps, vacuum devices, centrifugal forces, piezoelectric/ultrasonic pumps and acoustic forces); electrical or magnetic principles (e.g. electroosmotic flow, electrokinetic pumps, ferrofluidic plugs, electrohydrodynamic pumps, attraction or repulsion using magnetic forces and magnetohydrodynamic pumps); thermodynamic principles (e.g. gas bubble generation/phase-change-induced volume expansion); other kinds of surface-wetting principles (e.g. electrowetting, and optoelectrowetting, as well as chemically, thermally, structurally and radioactively induced surface-tension gradients); gravity; surface tension (e.g., capillary action); electrostatic forces (e.g., electroosmotic flow); centrifugal flow (substrate disposed on a compact disc and rotated); magnetic forces (e.g., oscillating ions causes flow); magnetohydrodynamic forces; and vacuum or pressure differential. In certain embodiments, combinations of two or more of the foregoing techniques may be employed in droplet actuators of the invention.

"Droplet operation" means any manipulation of a droplet on a droplet actuator. A droplet operation may, for example, include: loading a droplet into the droplet actuator; dispensing one or more droplets from a source droplet; splitting, separating or dividing a droplet into two or more droplets; transporting a droplet from one location to another in any direction; merging or combining two or more droplets into a single droplet; diluting a droplet; mixing a droplet; agitating a droplet; deforming a droplet; retaining a droplet in position; incubating a droplet; heating a droplet; vaporizing a droplet; cooling a droplet; disposing of a droplet; transporting a droplet out of a droplet actuator; other droplet operations described herein; and/or any combination of the foregoing. The terms "merge," "merging," "combine," "combining" and the like are used to describe the creation of one droplet from two or more droplets. It should be understood that when such a term is used in reference to two or more droplets, any combination of droplet operations that are sufficient to result in the combination of the two or more droplets into one droplet may be used. For example, "merging droplet A with droplet B," can be achieved by transporting droplet A into contact with a stationary droplet B, transporting droplet B into contact with a stationary droplet A, or transporting droplets A and B into contact with each other. The terms "splitting," "separating" and "dividing" are not intended to imply any particular outcome with respect to volume of the resulting droplets (i.e., the volume of the resulting droplets can be the same or different) or number of resulting droplets (the number of resulting droplets may be 2, 3, 4, 5 or more). The term "mixing" refers to droplet operations which result in more homogenous distribution of one or more components within a droplet. Examples of "loading" droplet operations include microdialysis loading, pressure assisted loading, robotic loading, passive loading, and pipette loading. Droplet operations may be electrode-mediated. In some cases, droplet operations are further facilitated by the use of hydrophilic and/or hydrophobic regions on surfaces and/or by physical obstacles. For examples of droplet operations, see the patents and patent applications cited above under the definition of "droplet actuator." "Filler fluid" means a fluid associated with a droplet operations substrate of a droplet actuator, which fluid is sufficiently immiscible with a droplet phase to render the droplet phase subject to electrode-mediated droplet operations. The filler fluid may, for example, be a low-viscosity oil, such as silicone oil. Other examples of filler fluids are provided in International Patent Application No. PCT/US2006/047486, entitled, "Droplet-Based Biochemistry," filed on December 11, 2006; International Patent Application No. PCT/US2008/072604, entitled "Use of additives for enhancing droplet actuation," filed on August 8, 2008; and U.S. Patent Publication No. 20080283414, entitled "Electrowetting Devices," filed on May 17, 2007; the entire disclosures of which are incorporated herein by reference. The filler fluid may fill the entire gap of the droplet actuator or may coat one or more surfaces of the droplet actuator. Filler fluid may be conductive or non-conductive.

"Immobilize" with respect to magnetically responsive beads, means that the beads are substantially restrained in position in a droplet or in filler fluid on a droplet actuator. For example, in one embodiment, immobilized beads are sufficiently restrained in position to permit execution of a splitting operation on a droplet, yielding one droplet with substantially all of the beads and one droplet substantially lacking in the beads.
"Magnetically responsive" means responsive to a magnetic field. "Magnetically responsive beads" include or are composed of magnetically responsive materials. Examples of magnetically responsive materials include paramagnetic materials, ferromagnetic materials, ferrimagnetic materials, and metamagnetic materials. Examples of suitable paramagnetic materials include iron, nickel, and cobalt, as well as metal oxides, such as Fe₃O₄, BaFe₁₂O_{19,} CoO, NiO, Mn₂O₃, Cr₂O₃, and CoMnP.
"Transporting into the magnetic field of a magnet," "transporting towards a magnet," and the like, as used herein to refer to droplets and/or magnetically responsive beads within droplets, is intended to refer to transporting into a region of a magnetic field capable of substantially attracting magnetically responsive beads in the droplet. Similarly, "transporting away from a magnet or magnetic field," "transporting out of the magnetic field of a magnet," and the like, as used herein to refer to droplets and/or magnetically responsive beads within droplets, is intended to refer to transporting away from a region of a magnetic field capable of substantially attracting magnetically responsive beads in the droplet, whether or not the droplet or magnetically responsive beads is completely removed from the magnetic field. It will be appreciated that in any of such cases described herein, the droplet may be transported towards or away from the desired region of the magnetic field, and/or the desired region of the magnetic field may be moved towards or away from the droplet. Reference to an electrode, a droplet, or magnetically responsive beads being "within" or "in" a magnetic field, or the like, is intended to describe a situation in which the electrode is situated in a manner which permits the electrode to transport a droplet into and/or away from a desired region of a magnetic field, or the droplet or magnetically responsive beads is/are situated in a desired region of the magnetic field, in each case where the magnetic field in the desired region is capable of substantially attracting any magnetically responsive beads in the droplet. Similarly, reference to an electrode, a droplet, or magnetically responsive beads being "outside of" or "away from" a magnetic field, and the like, is intended to describe a situation in which the electrode is situated in a manner which permits the electrode to transport a droplet away from a certain region of a magnetic field, or the droplet or magnetically responsive beads is/are situated in away from a certain region of the magnetic field, in each case where the magnetic field in such region is not capable of substantially attracting any magnetically responsive beads in the droplet.
"Washing" with respect to washing a bead means reducing the amount and/or concentration of one or more substances in contact with the bead or exposed to the bead from a droplet in contact with the bead. The reduction in the amount and/or concentration of the substance may be partial, substantially complete, or even complete. The substance may be any of a wide variety of substances; examples include target substances for further analysis, and unwanted substances, such as components of a sample, contaminants, and/or excess reagent. In some embodiments, a washing operation begins with a starting droplet in contact with a magnetically responsive bead, where the droplet includes an initial amount and initial concentration of a substance. The washing operation may proceed using a variety of droplet operations. The washing operation may yield a droplet including the magnetically responsive bead, where the droplet has a total amount and/or concentration of the substance which is less than the initial amount and/or concentration of the substance. Examples of suitable washing techniques are described in Pamula et al., U.S. Patent 7,439,014, entitled "Droplet-Based Surface Modification and Washing," granted on October 21, 2008, the entire disclosure of which is incorporated herein by reference. The terms "top," "bottom," "over," "under," and "on" are used throughout the description with reference to the relative positions of components of the droplet actuator, such as relative positions of top and bottom substrates of the droplet actuator. It will be appreciated that the droplet actuator is functional regardless of its orientation in space.
When a liquid in any form (e.g., a droplet or a continuous body, whether moving or stationary) is described as being "on", "at", or "over" an electrode, array, matrix or surface, such liquid could be either in direct contact with the electrode/array/matrix/surface, or could be in contact with one or more layers or films that are interposed between the liquid and the electrode/array/matrix/surface.
When a droplet is described as being "on" or "loaded on" a droplet actuator, it should be understood that the droplet is arranged on the droplet actuator in a manner which facilitates using the droplet actuator to conduct one or more droplet operations on the droplet, the droplet is arranged on the droplet actuator in a manner which facilitates sensing of a property of or a signal from the droplet, and/or the droplet has been subjected to a droplet operation on the droplet actuator.

### 5 Brief Description of the Drawings

Figure 1 illustrates a perspective view of an example of a sample-to-answer digital microfluidics molecular diagnostic platform;
Figure 2 illustrates a perspective view of another example of a droplet actuator that is suitable for sample-to-answer multiplexed detection of one or more pathogens in a single biological sample;
Figure 3 illustrates a perspective view of an imaging system for multiplexed detection of xTAG beads;
Figure 4 illustrates a flow diagram of an example of a protocol for sample-to-answer detection of respiratory viruses in a biological sample;
Figure 5 illustrates a top view of the droplet actuator of Figure 1 and illustrates an example of droplet actuator architecture suitable for performing the respiratory virus detection protocol of Figure 4;
Figure 6 shows a bar graph of a comparison of the xTAG RVP assay performed on-bench and on a droplet actuator; and
Figures 7A and 7B illustrate a side view of a portion an example of a droplet actuator and illustrate a process of multiplexing immunoassays using multiple types of beads in a single droplet.

### 6 Description

The present invention provides a molecular diagnostic platform that uses digital microfluidics and bead technologies for multiplexed molecular testing. More specifically, by use of an integrated droplet actuator in combination with a detection system, sample-to-answer molecular assays may be multiplexed using multiple types of beads (coded beads) in a single sample droplet. The droplet actuator device uses a large input sample volume (e.g., about 1 milliliter (mL)) and provides for rapid capture and concentration of multiple target analytes (e.g., nucleic acids) from a single sample for subsequent molecular diagnostic assays (e.g., RT-PCR) on the same droplet actuator. The droplet actuator of the invention is an inexpensive and simple-to-use disposable device that provides for high quality testing in a variety of clinical settings including hospital laboratories and at the point-of-care.

In one embodiment, the molecular diagnostics platform and methods of the invention provide for multiplexed detection of respiratory viruses in a single biological sample (e.g., nasopharyngeal sample) in less than about 60 minutes or less than about 30 minutes or less than about 20 minutes.

In another embodiment, the molecular diagnostics platform and methods of the invention provide for high throughput molecular diagnostics, i.e., multiple different tests (e.g., xMAP bead array panels) performed in parallel.

In yet another embodiment, the invention provides a method of multiplexing immunoassays in a droplet actuator using a single droplet that contains multiple types of beads.

### 6.1 Multiplexed Molecular Diagnostic Platform

The molecular diagnostic platform of the invention includes digital microfluidic liquid-handling technology and bead-based analyte capture technologies for multiplexed molecular analysis (e.g., nucleic acid testing, immunoassays). The molecular diagnostic platform uses imaging technology for bead-based discrimination and detection of one or more analytes in a biological sample.

### 6.1.1 Digital Microfluidics

Digital microfluidic technology conducts droplet operations on discrete droplets by electrical control of their surface tension (electrowetting). The droplets may be sandwiched between two substrates, a bottom substrate and a top substrate separated by a gap. The bottom substrate may, for example, be a printed circuit board (PCB) with an arrangement of electrically addressable electrodes. The top substrate may, for example, be an injection molded plastic top substrate with a reference electrode plane made, for example, from conductive ink or indium tin oxide. The bottom substrate and the top substrate may be coated with a hydrophobic material. The space around the droplets (i.e., the gap between bottom and top substrates) may be filled with an immiscible inert fluid, such as silicone oil, to prevent evaporation of the droplets and to facilitate their transport within the device. An electric field, formed when voltage is applied to a control electrode on the bottom substrate, reduces the interfacial tension between the droplet and the electrode. This effect may be used to transport droplets using surface energy gradients established by activating a pattern of control electrodes on the bottom substrate along any path of contiguous electrodes. Other droplet operations may be effected by varying the patterns of voltage activation; examples include merging, splitting, mixing, and dispensing of droplets.

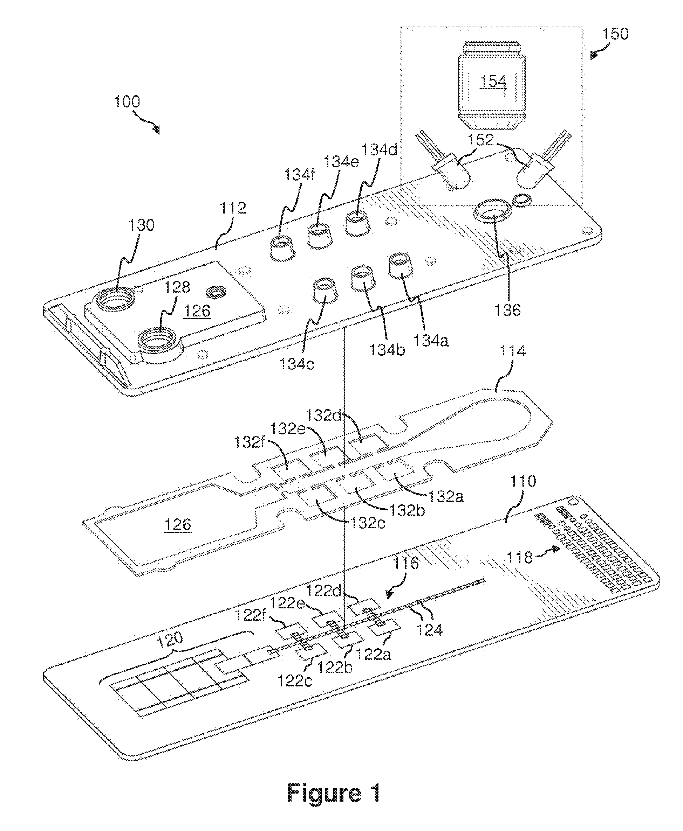

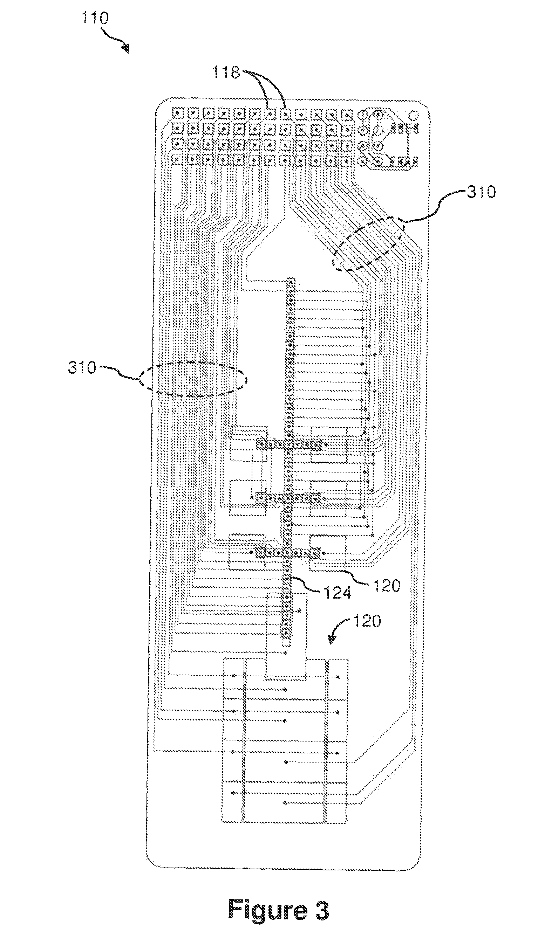

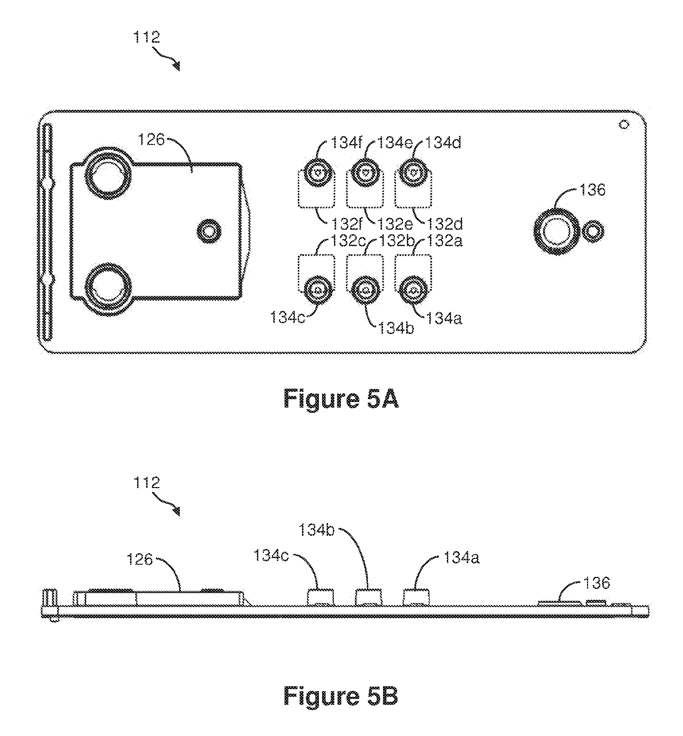

**Figure 1** illustrates a perspective view of an example of a sample-to-answer digital microfluidics molecular diagnostic platform 100. Molecular diagnostic platform 100 may include a droplet actuator 110 in combination with an imaging system 112. In one embodiment, droplet actuator 110 is configured for integrated sample preparation and nucleic acid testing of a single sample. Droplet actuator 110 may include a bottom substrate 114 and a top substrate 116 that are separated by a gap. Bottom substrate 114 may, for example, be formed from PCB, plastic, silicon, or other substantially nonconductive or insulated substrate. Top substrate 116 may, for example, be formed of a molded material, such injection-molded plastic, or may be formed from PCB, plastic, silicon, or even from a conductive substrate. Dispensing reservoirs may be integrated into top substrate 116. Reservoirs may, for example, be allocated as a sample dispensing reservoir 118 for preparing and dispensing sample fluids (e.g., 1 mL nasopharyngeal swab elute) and one or more reagent dispensing reservoirs 120, i.e., reagent dispensing reservoirs 120a through 120f, for dispensing different reagent fluids. Sample dispensing reservoir 118 includes a sample input port 122 for loading sample fluids and a reagent input port 124 for loading sample preparation reagents (e.g., lysis buffer, nucleic acid capture beads). Sample dispensing reservoir 118 may be of sufficient size to contain a large volume of fluid, e.g., about 1.5 mL. Sample dispensing reservoir 118 and reagent dispensing reservoirs 120, are aligned with dispensing electrodes and interconnected through an arrangement, such as a path or array, of droplet operations electrodes (e.g., electrowetting electrodes). Droplet operations are conducted atop these electrodes within the gap. The arrangement of dispensing electrodes and droplet operations electrodes are described in more detail in reference to Figure 5. A detection window 126 is included in top substrate 116. Detection window 126 may be configured to transmit signal from within the gap to a sensor and/or electromagnetic energy from an external source into the gap. Appropriate transparency may vary. The window may be formed to direct and/or filter light, e.g., as a lens or a filter which excludes certain wavelengths. In operation, detection window 126 may be positioned in proximity of imaging system 112. An example of imaging system 112 is described in reference to Figure 3.

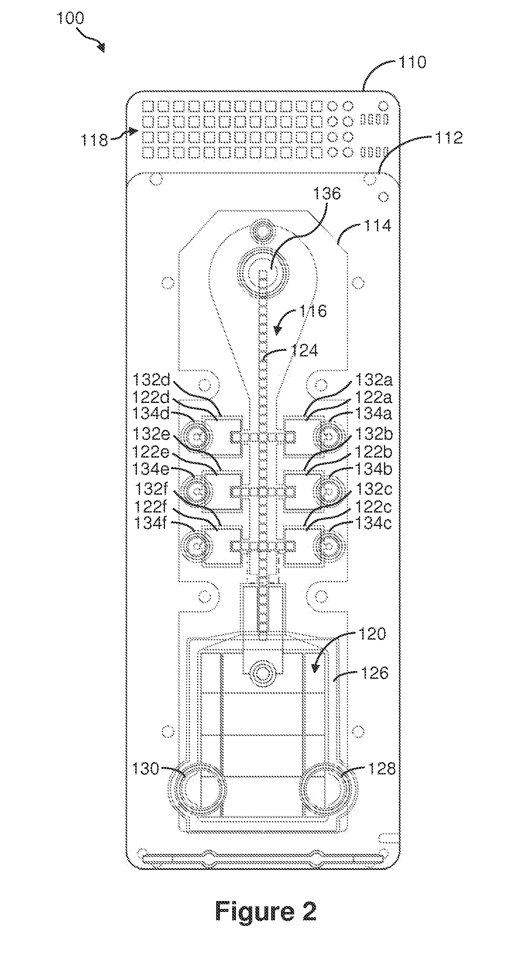

**Figure 2** illustrates a perspective view of another example of a droplet actuator 200 that is suitable for sample-to-answer multiplexed detection of one or more pathogens in a single biological sample. Droplet actuator 200 may include a bottom substrate 210 and a top substrate 212 that are separated at least in one or more regions thereof by a gap. Bottom substrate 210 may, for example, be a PCB or other suitable substrate. Bottom substrate 210 may include an arrangement of droplet operations electrodes 214 (e.g., electrowetting electrodes). Droplet operations are conducted atop droplet operations electrodes 214 on a droplet operations surface. An arrangement of electrical contacts 216 are provided on bottom substrate 210 for electrically controlling electrodes 214 or other components of droplet actuator 200, such as sensors, heaters, electromagnets, diodes, etc. Top substrate 212 may, for example, be formed of a molded material, such as injection-molded plastic, or from another suitable material. Dispensing reservoirs 218 may be integrated into top substrate 212. Dispensing reservoirs 218 may, for example, be allocated as a sample dispensing reservoir 218 for dispensing sample fluids (e.g., 1 mL nasopharyngeal swab elute) and one or more reagent dispensing reservoirs 220, i.e., reagent dispensing reservoirs 220a through 220g, for dispensing different reagent fluids. Sample dispensing reservoir 218 and reagent dispensing reservoirs 220, are aligned with dispensing electrodes and interconnected through an arrangement, such as a path or array, of droplet operations electrodes 214.

### 6.1.2 Bead-based Analyte Capture

Sample-to-answer molecular assays may be multiplexed using multiple types of analyte capture beads (coded beads) in a single sample droplet. Each type of analyte capture bead has an identifying trait for easily differentiating one type of bead from another. For example, the various types of analyte capture beads may be differentiated by color, fluorescence, size, density, surface properties, responsiveness to a magnetic field, radioactivity, and any combinations thereof. The analyte capture beads may be coated with a reagent (e.g., oligonucleotide sequences, antibodies, peptides, receptors) specific to a particular bioassay (e.g., nucleic acid testing, immunoassays). In a preferred embodiment, the analyte capture beads are magnetically responsive capture beads.

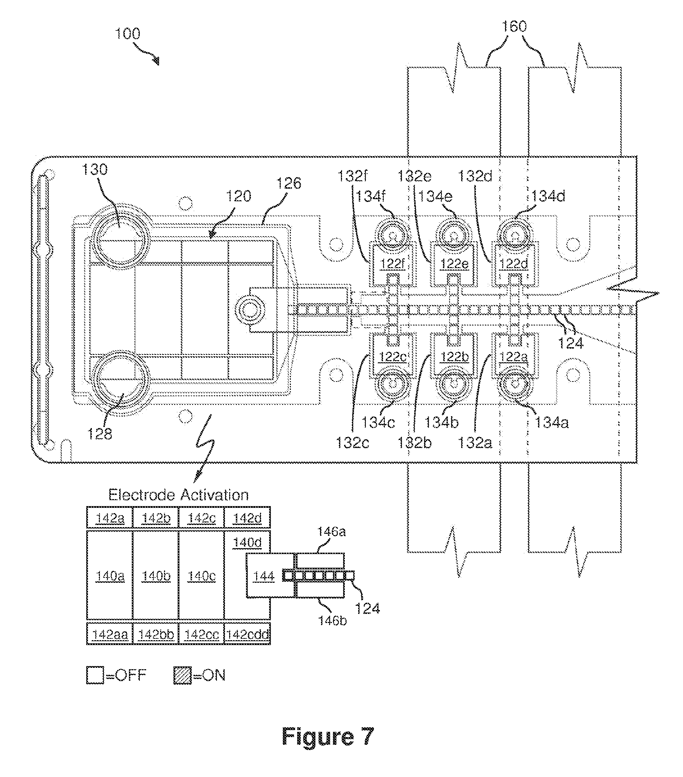

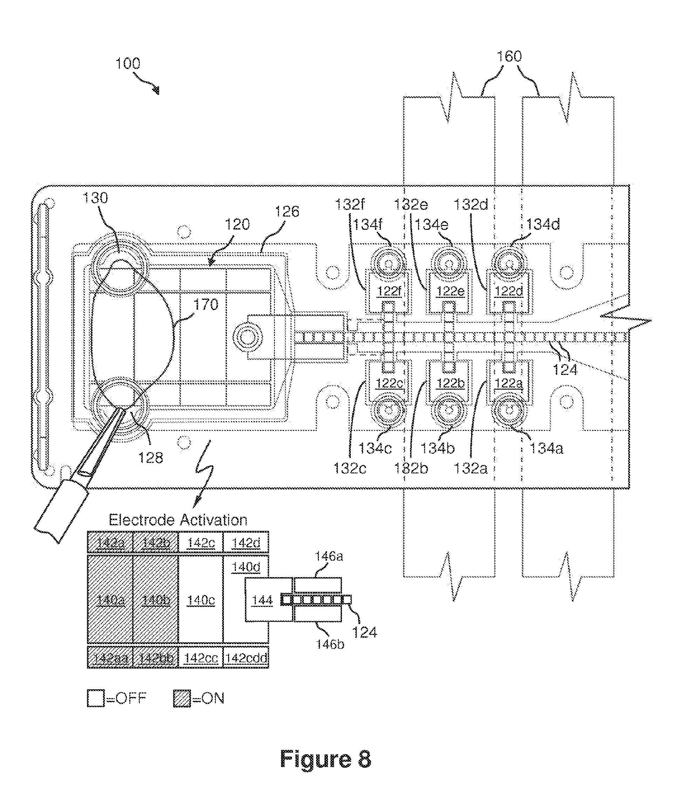

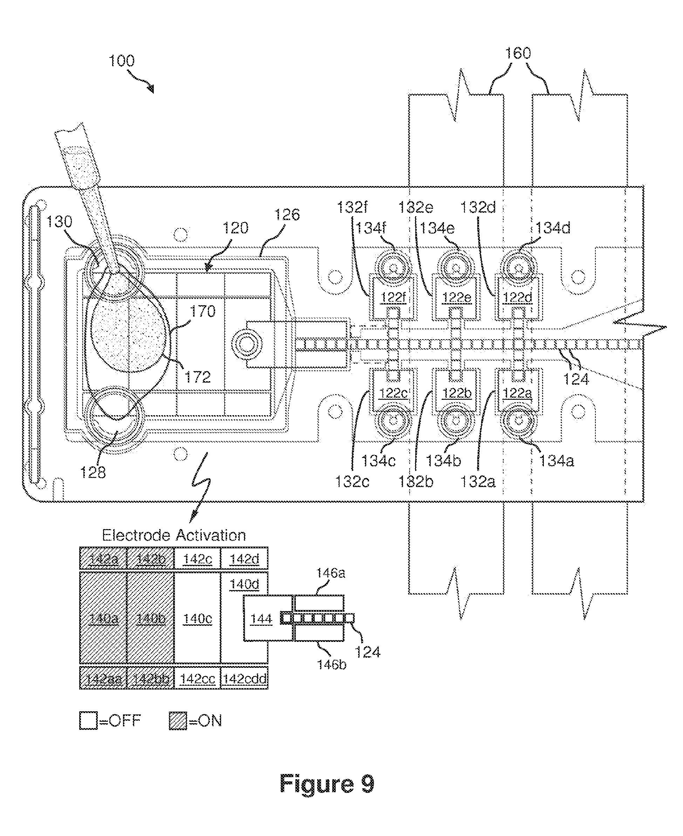

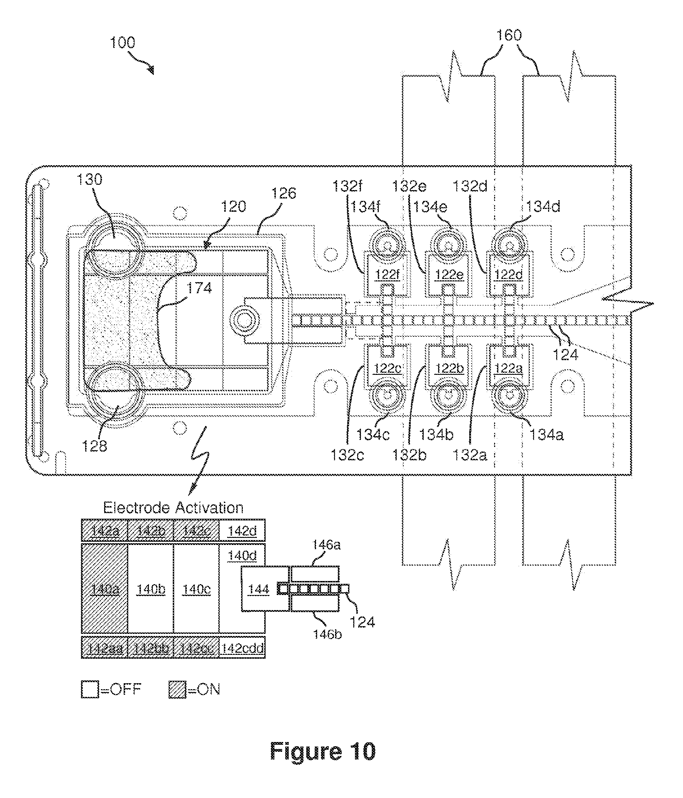

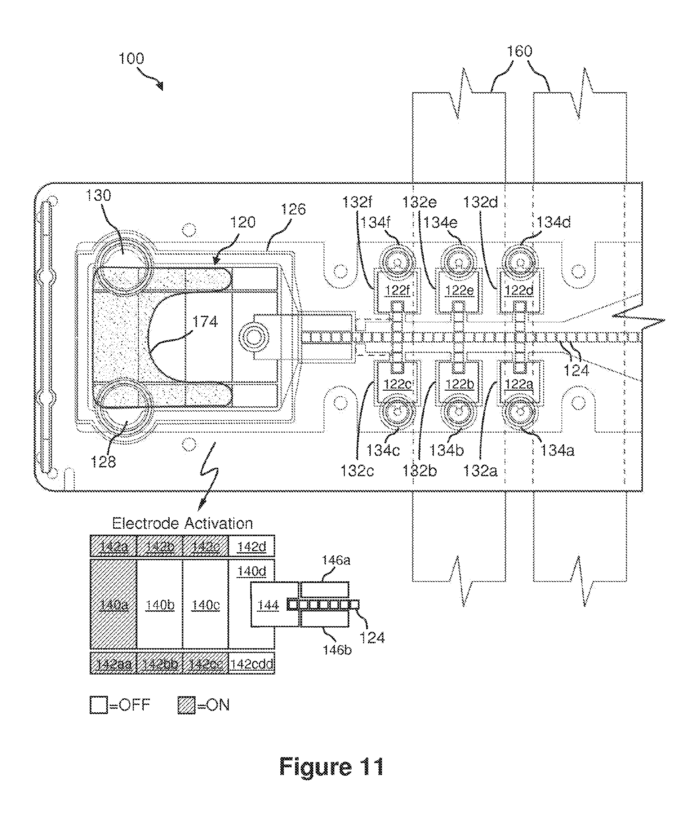

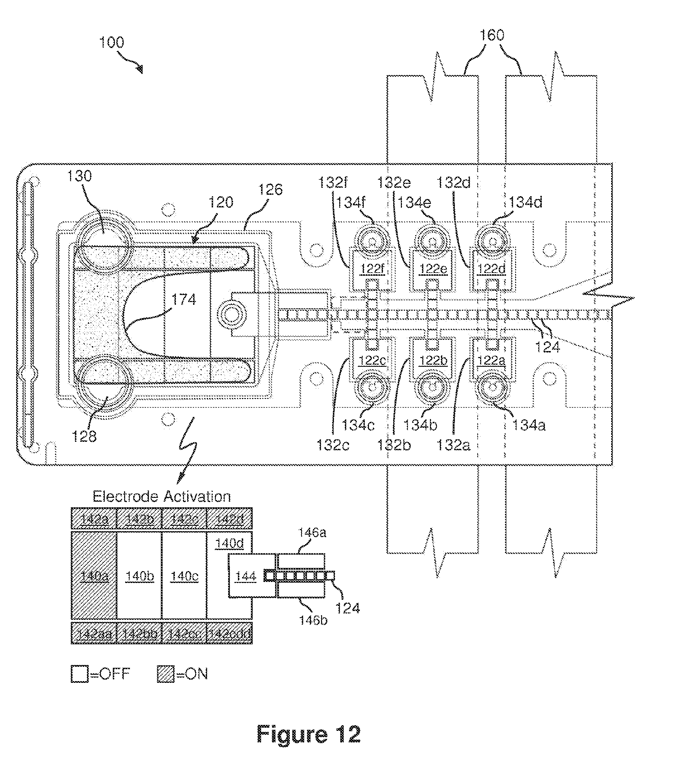

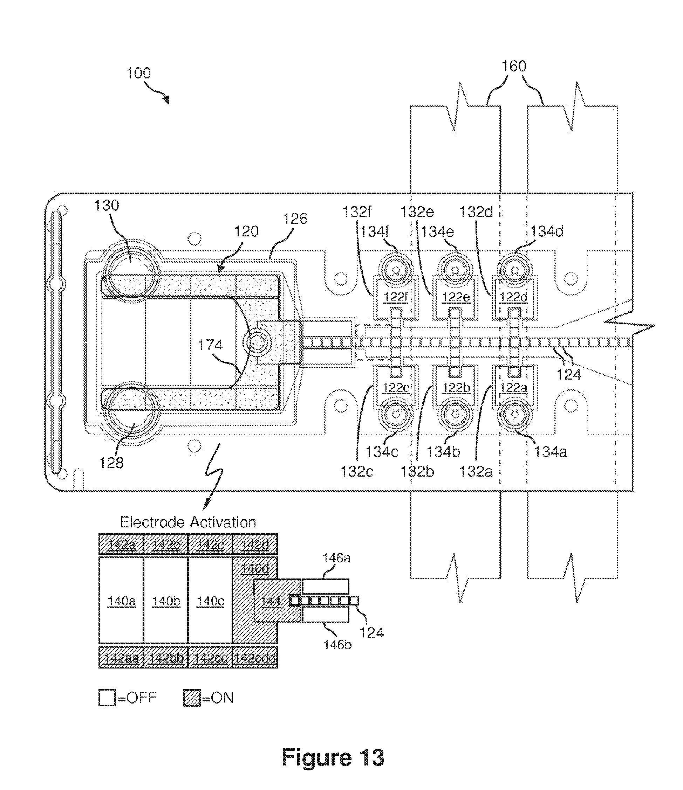

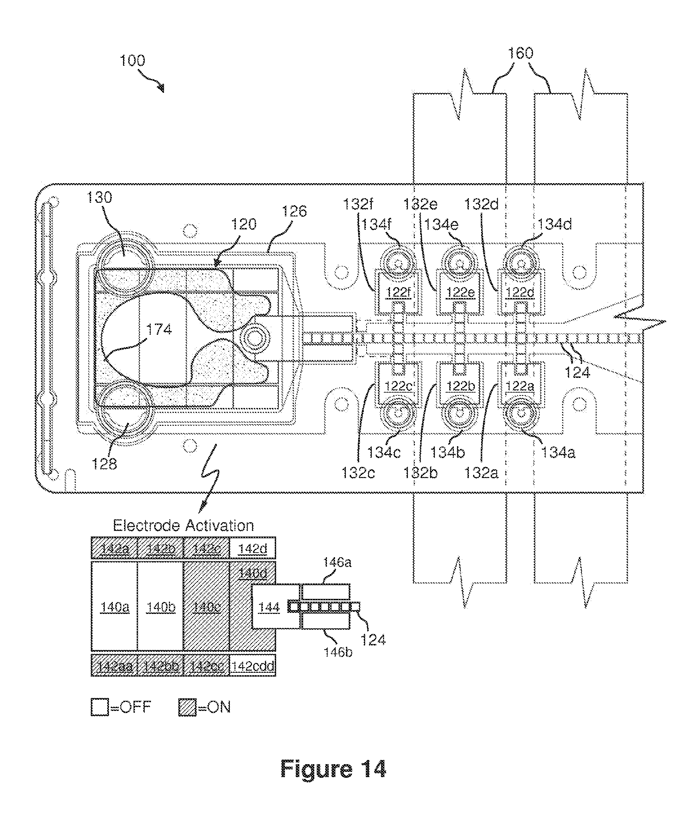

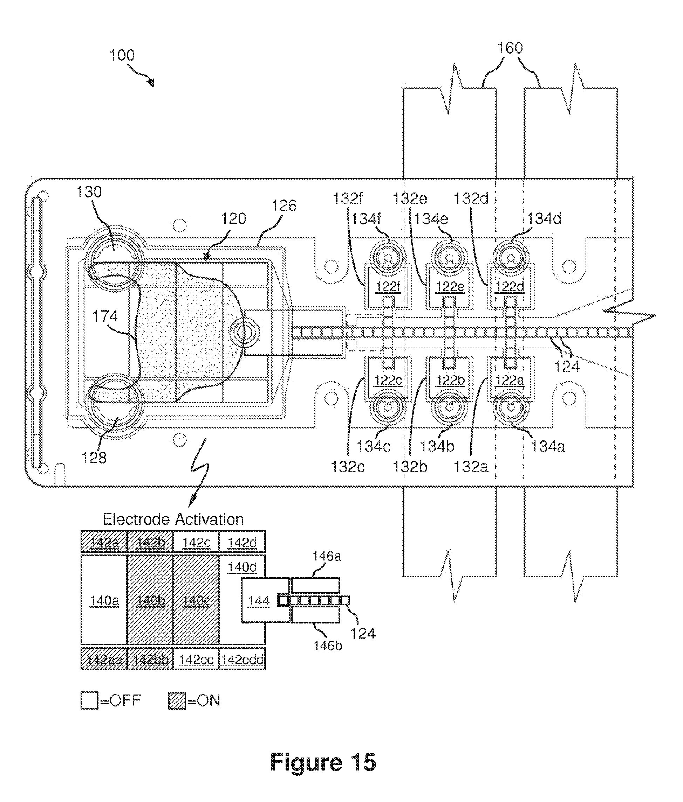

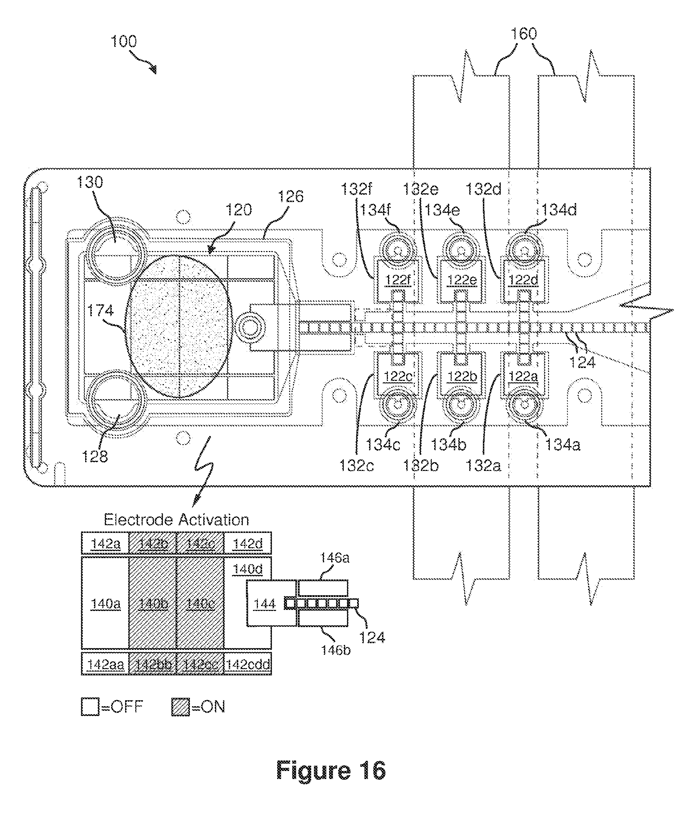

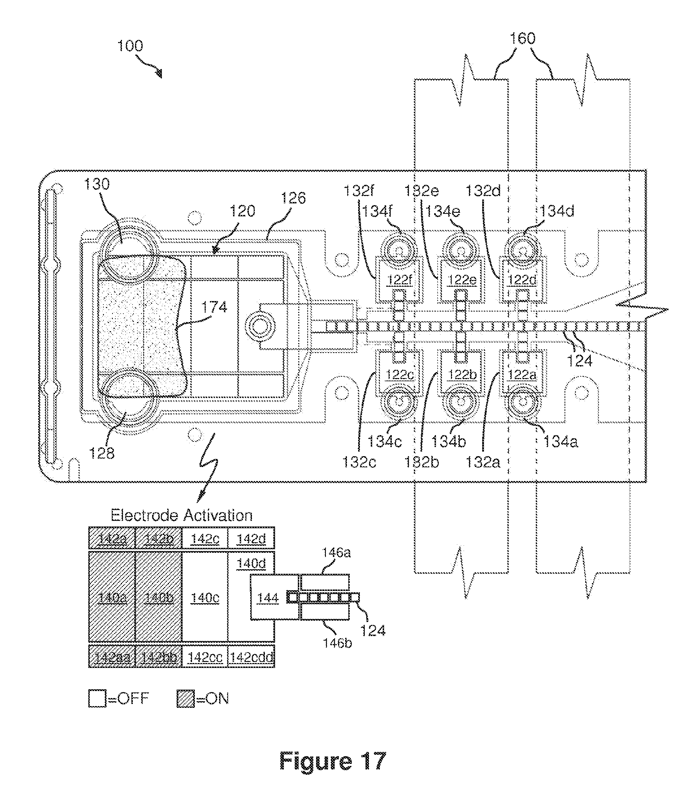

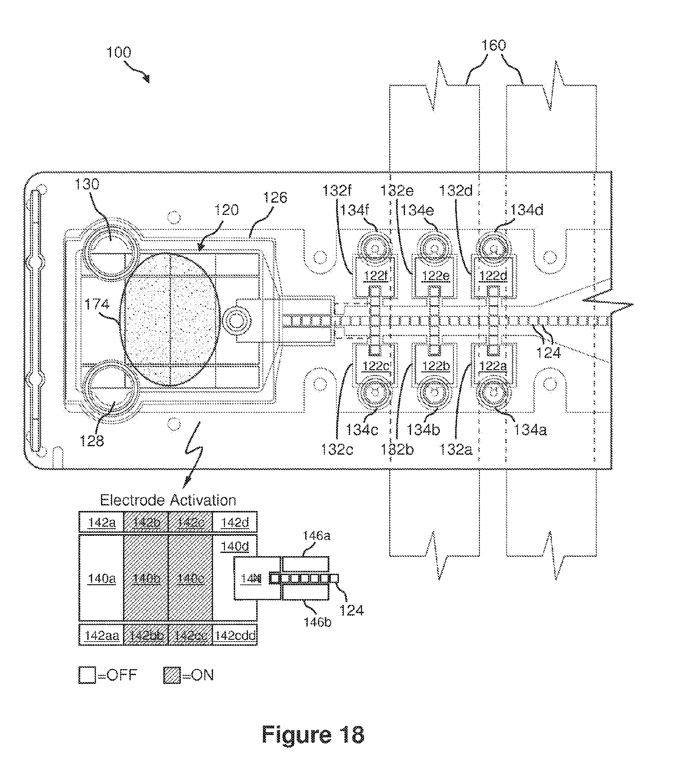

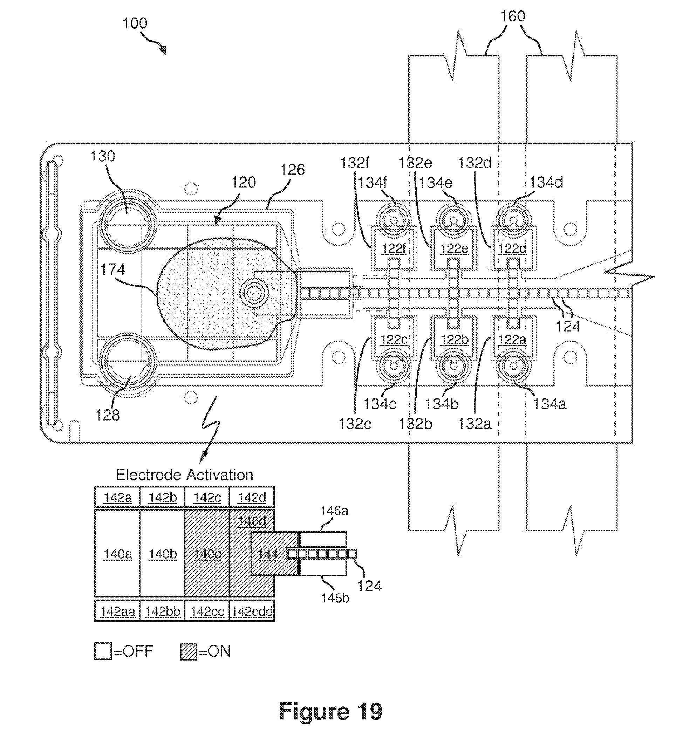

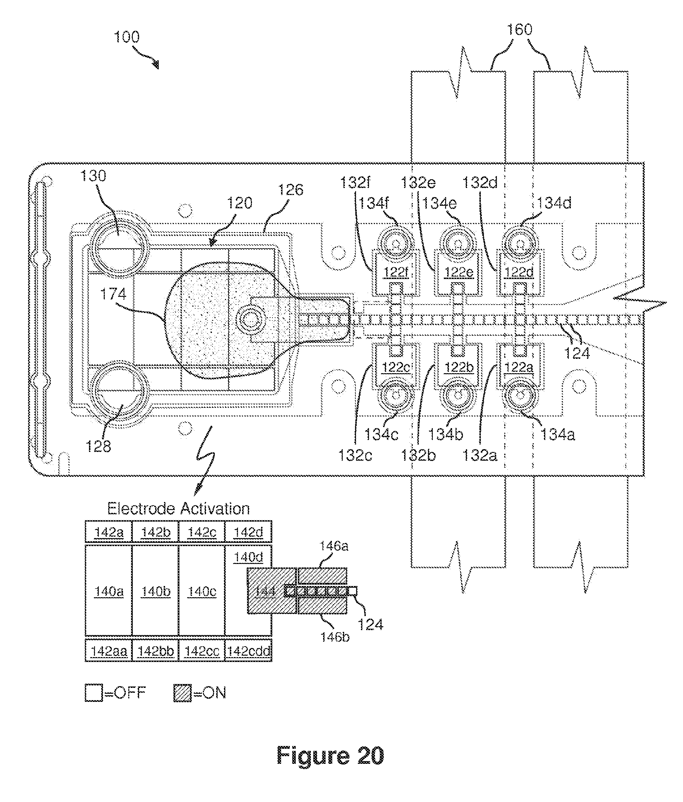

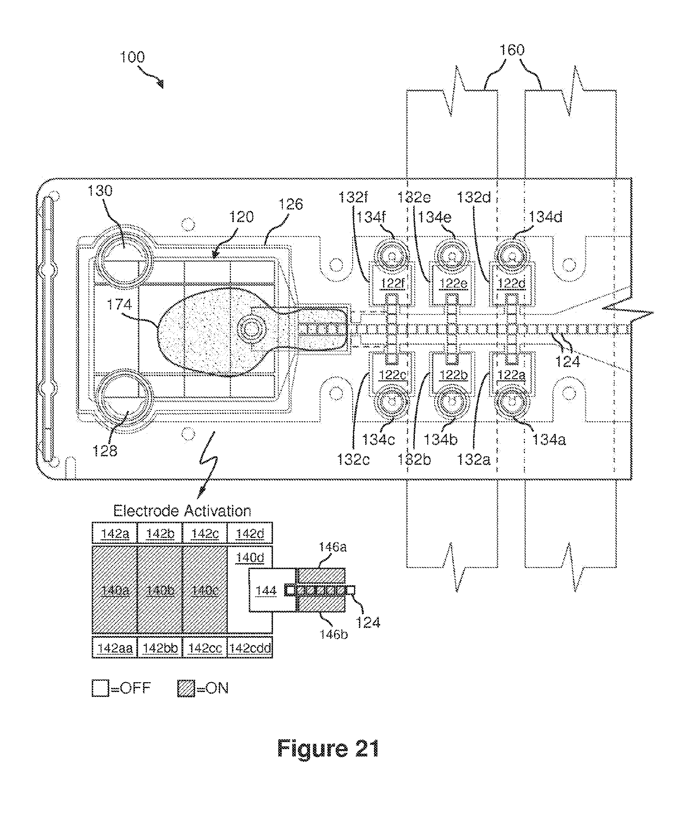

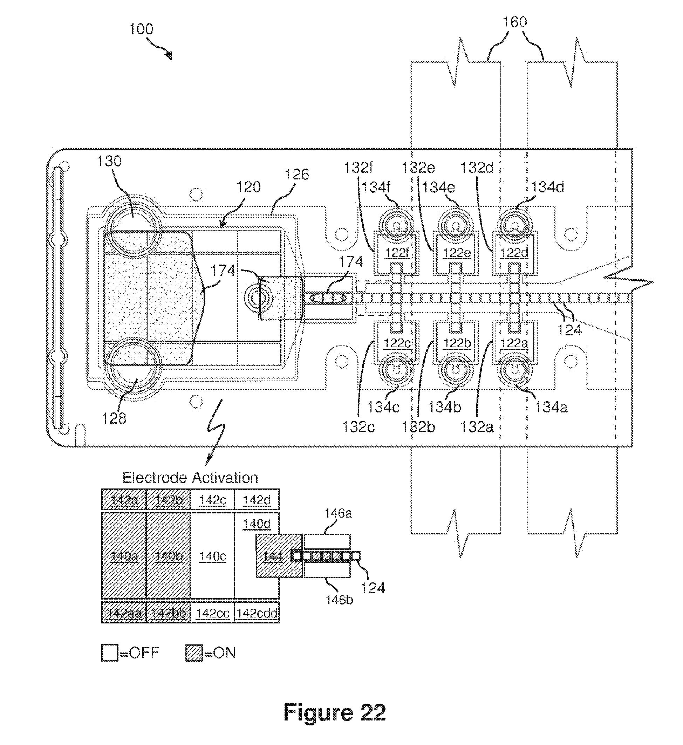

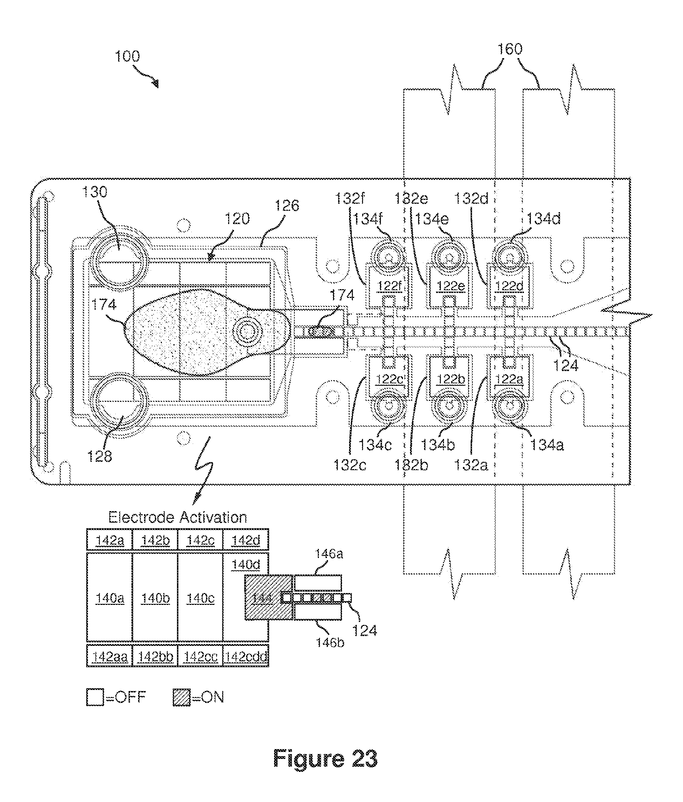

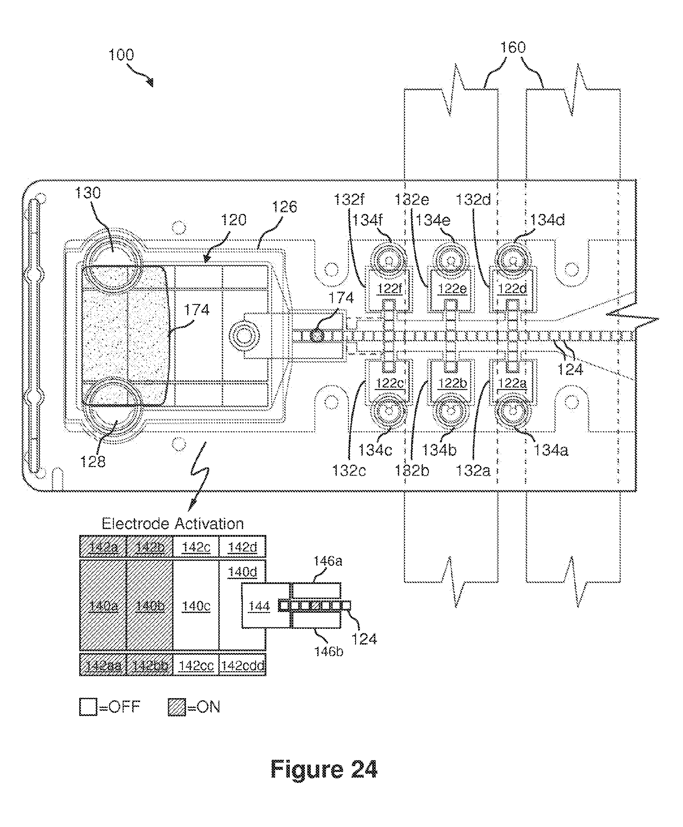

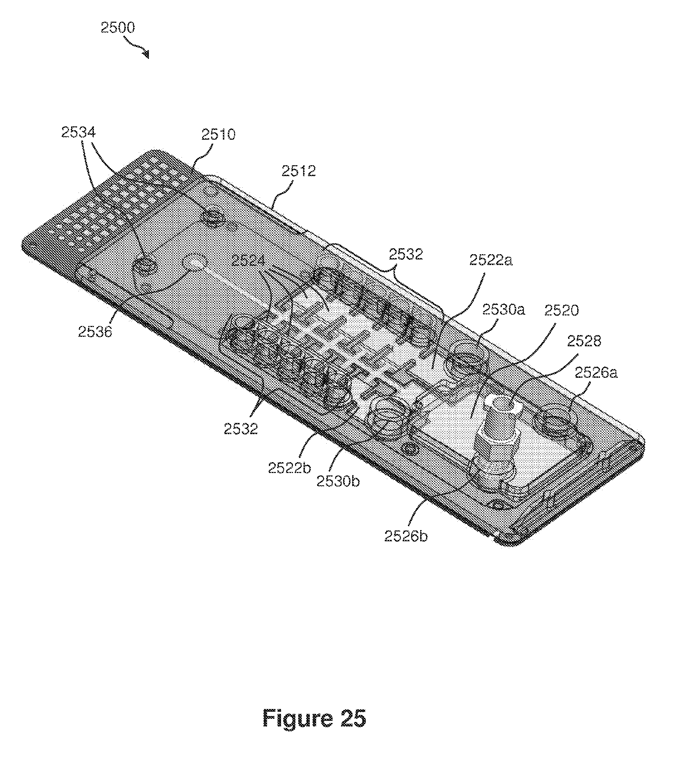

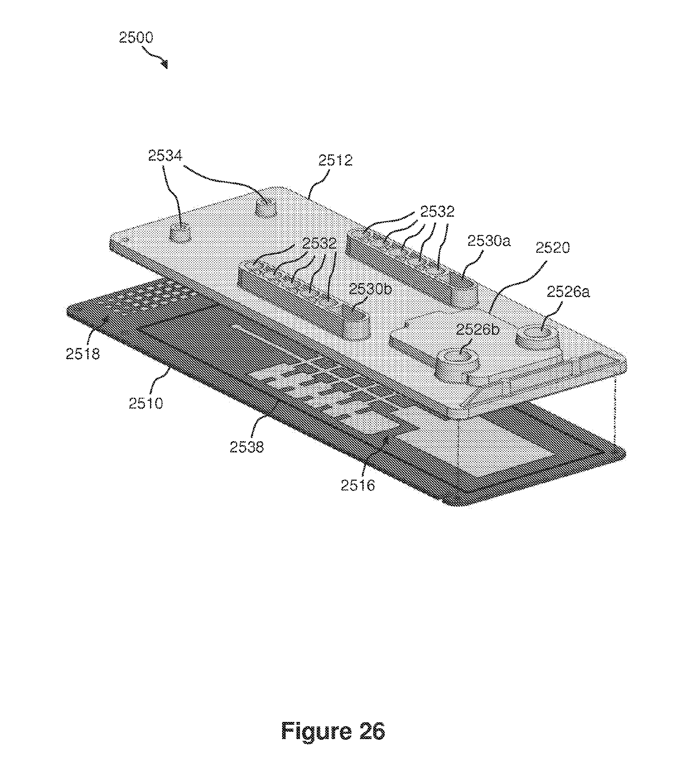

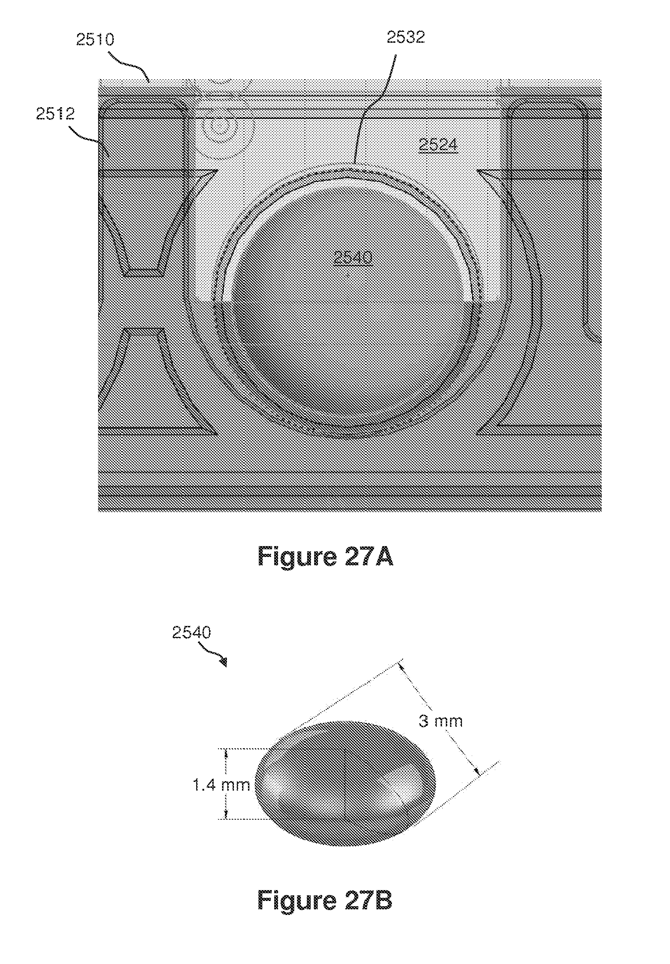

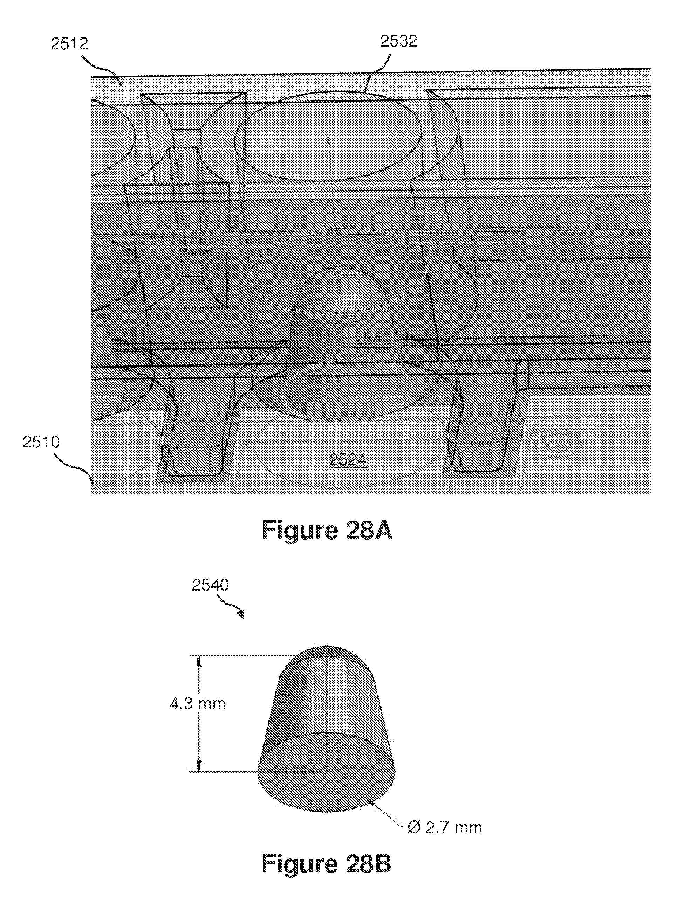

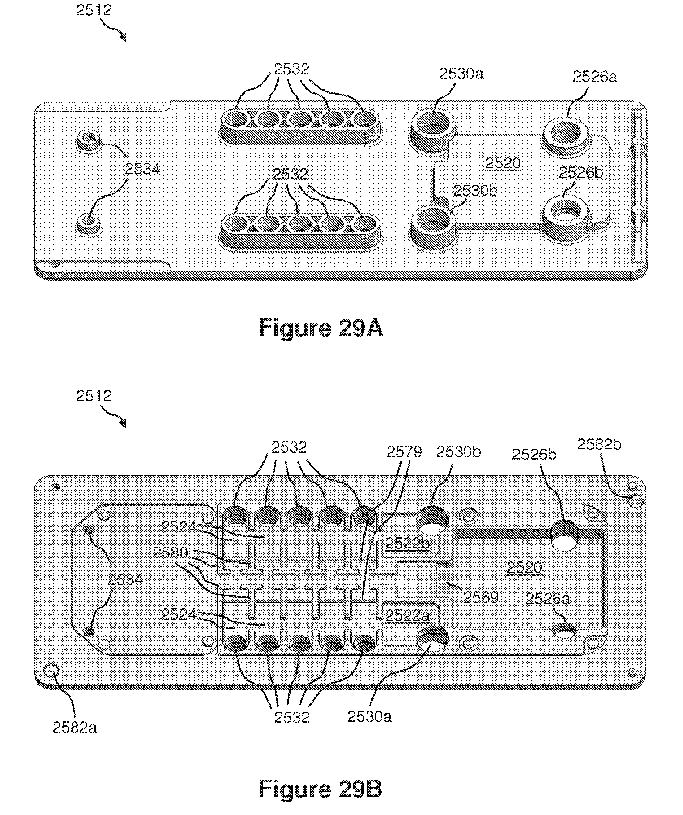

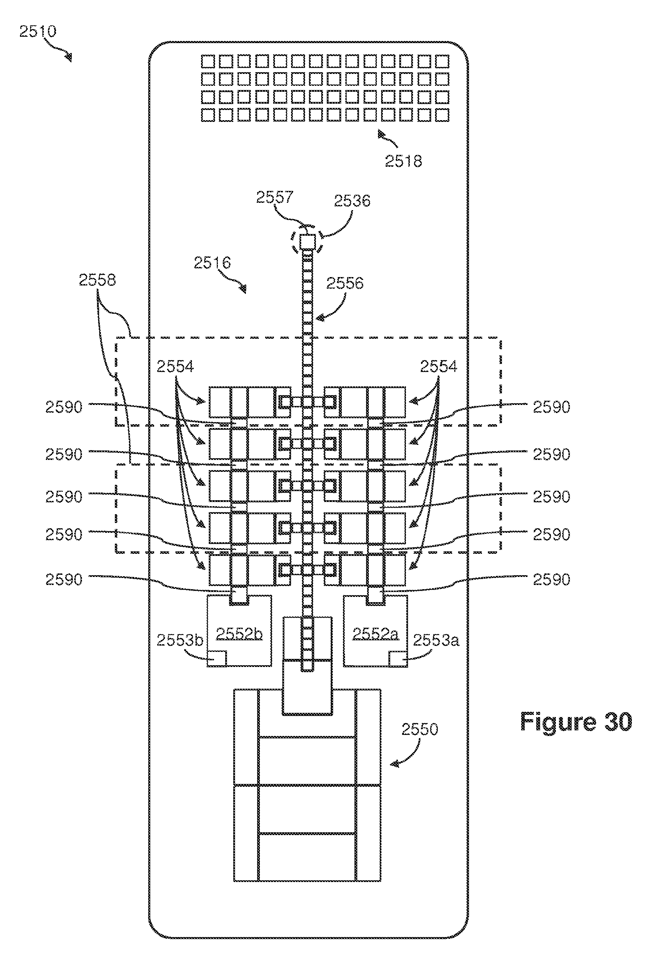

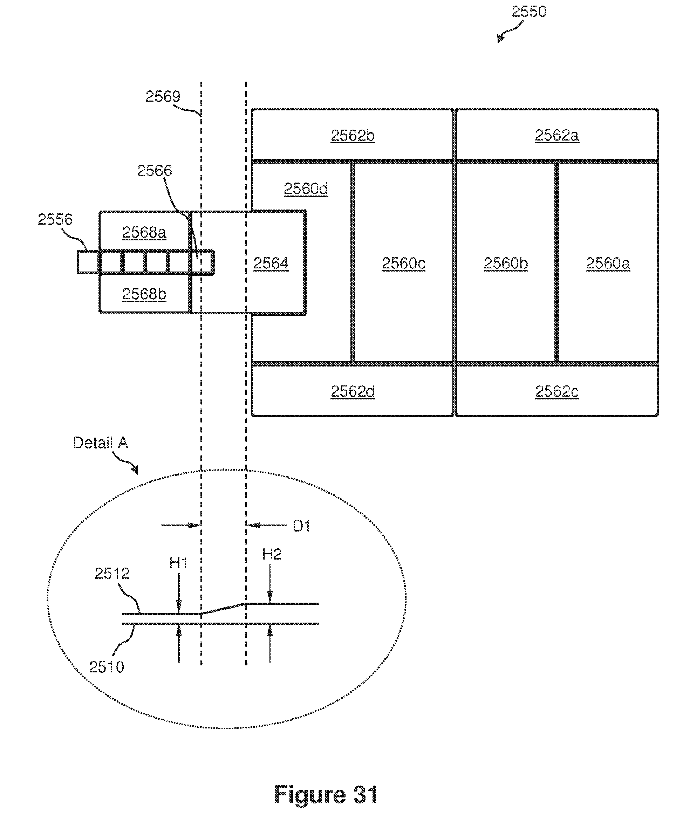

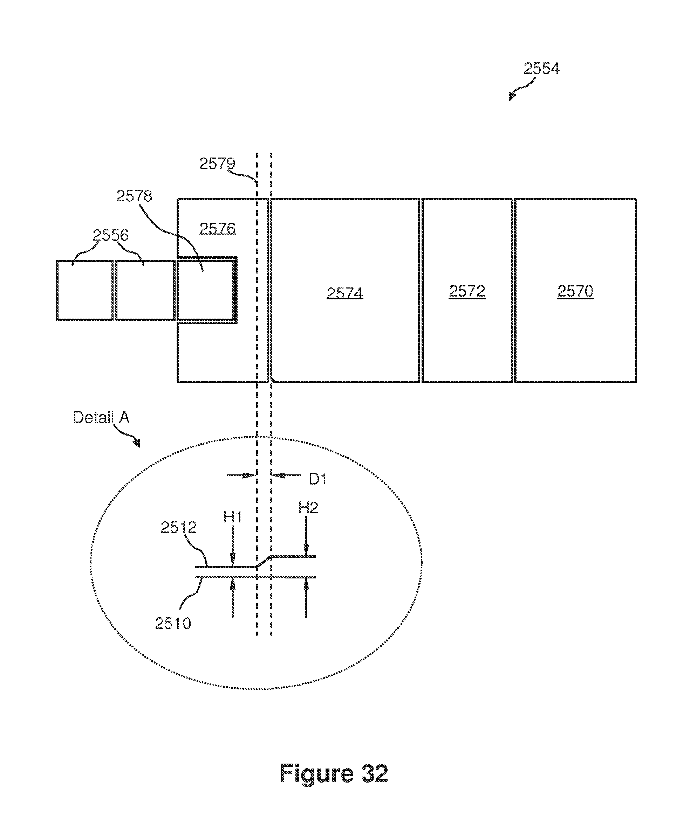

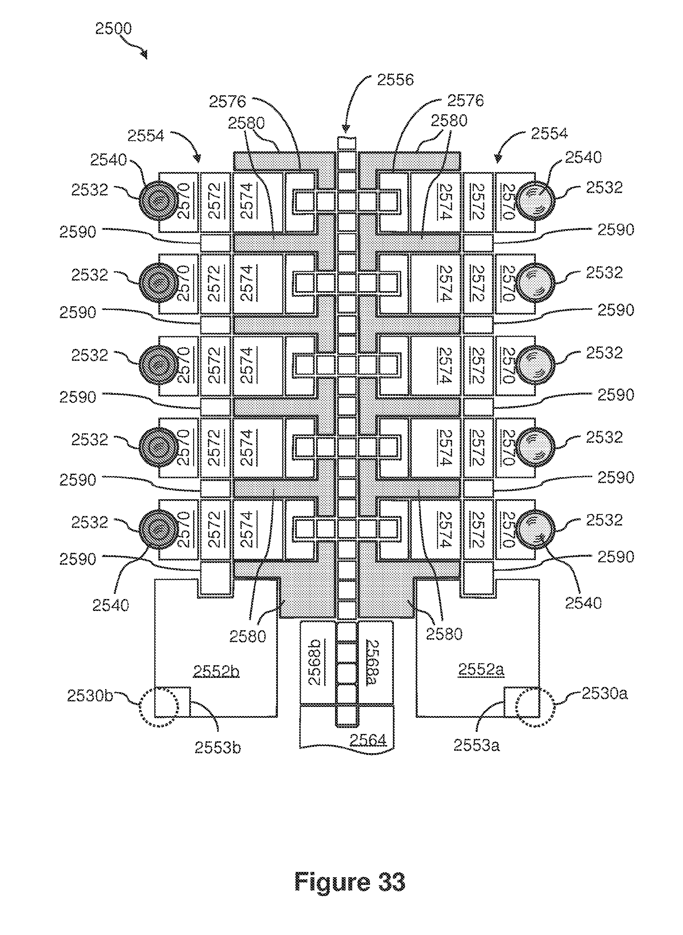

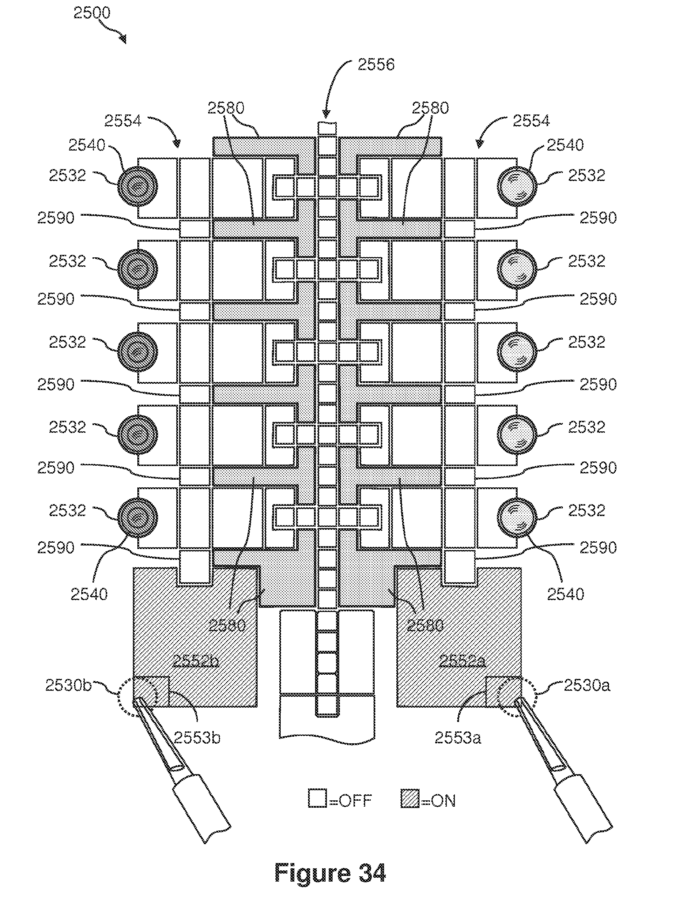

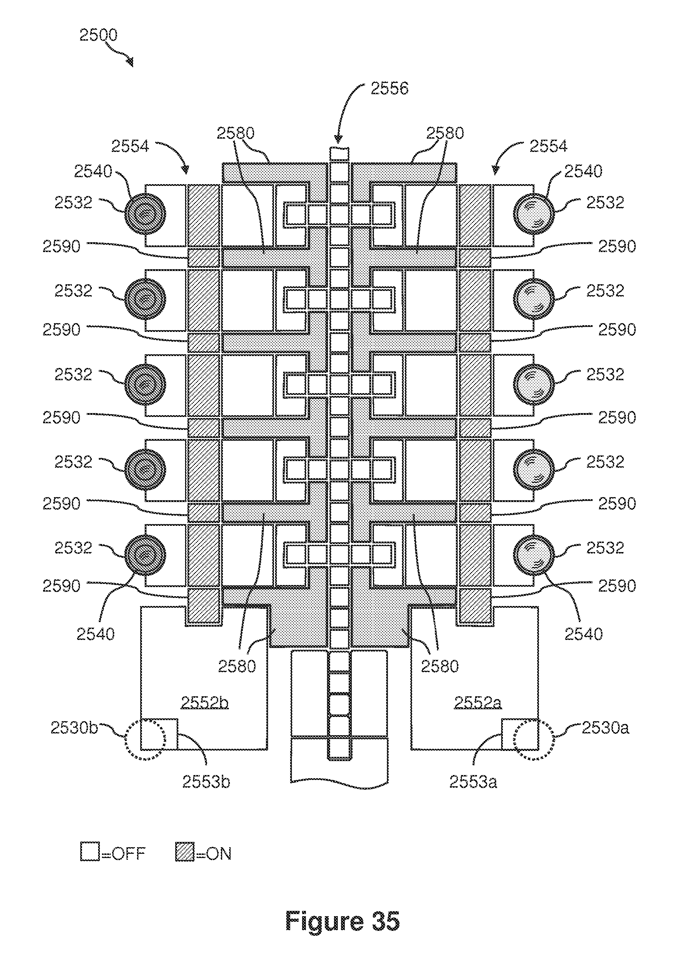

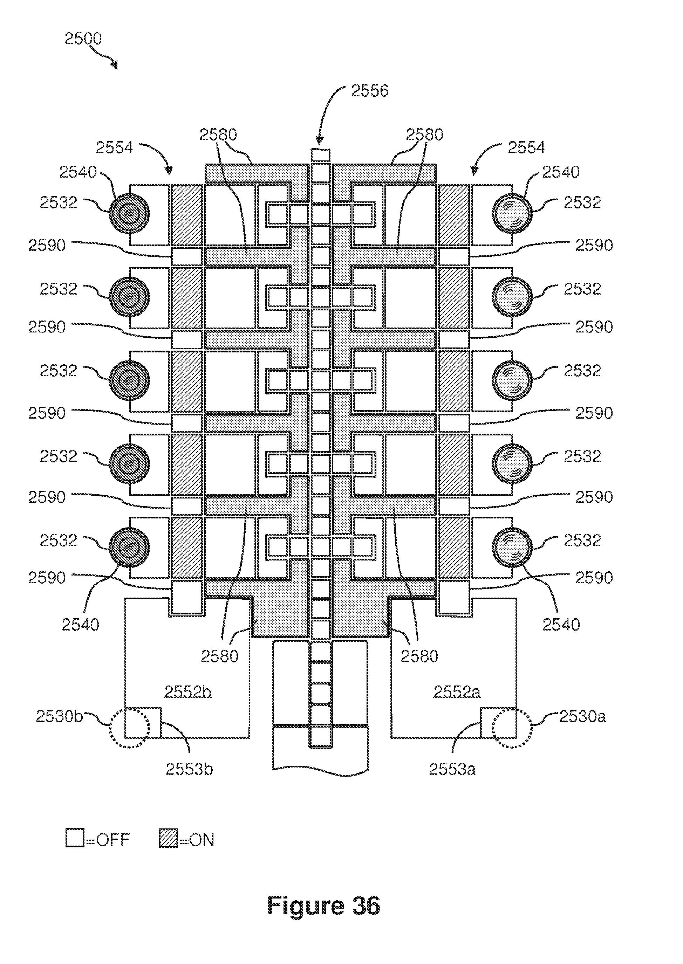

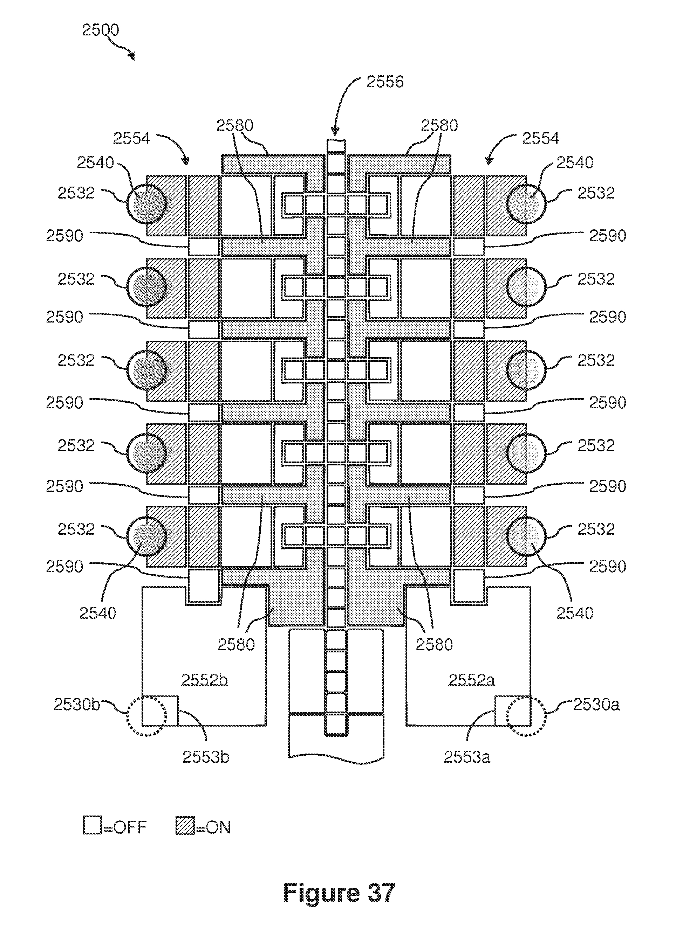

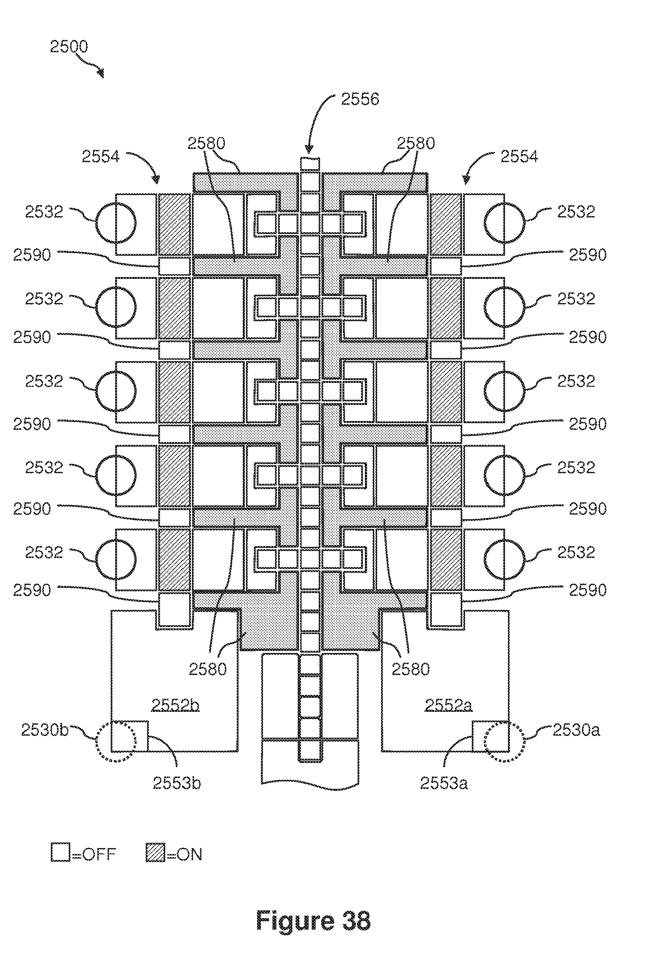

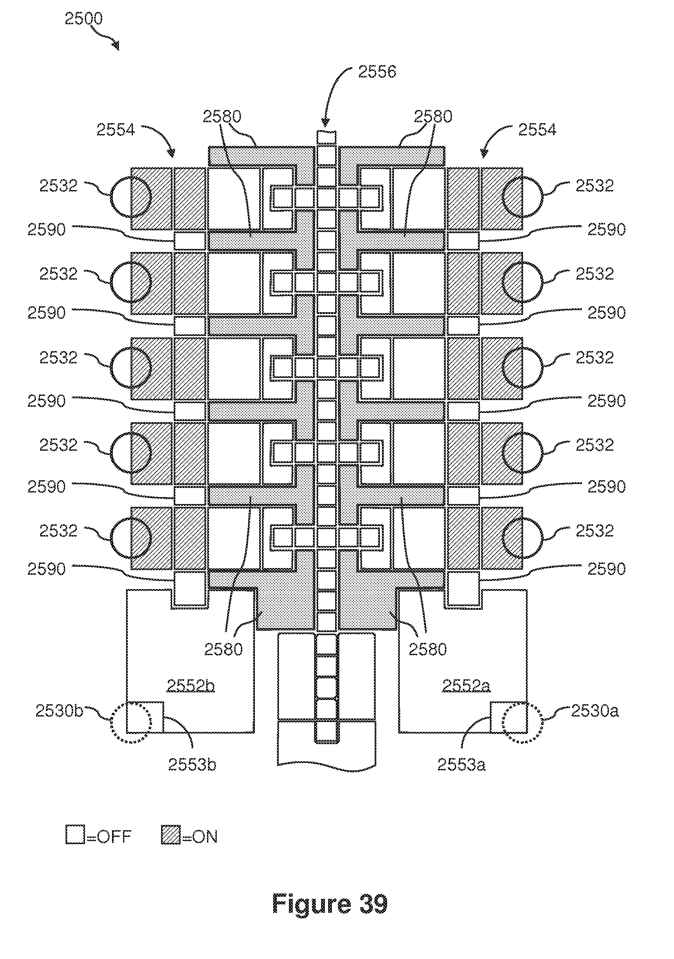

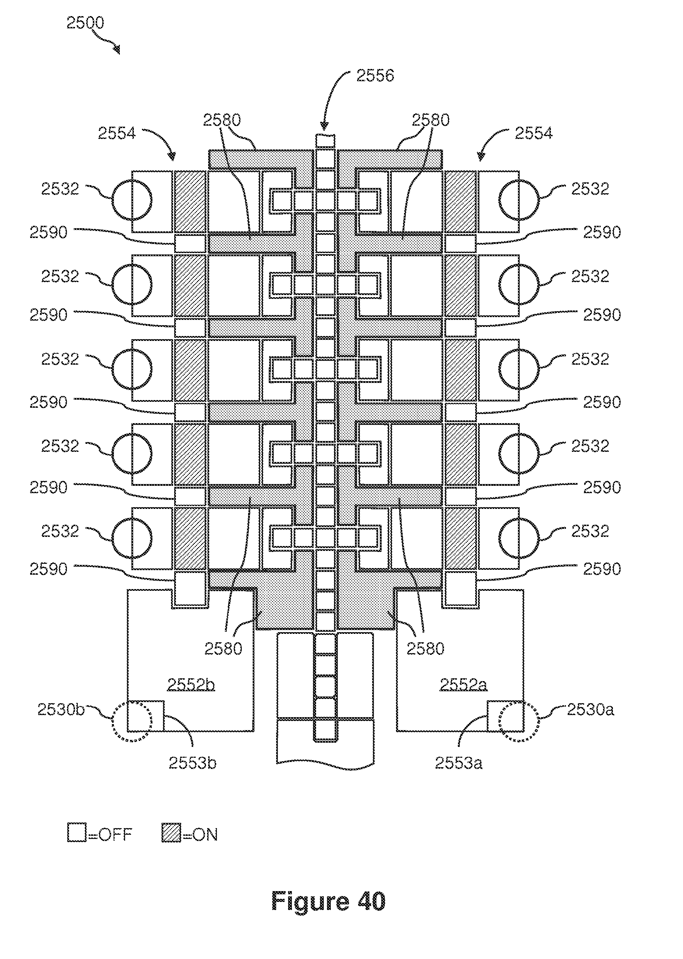

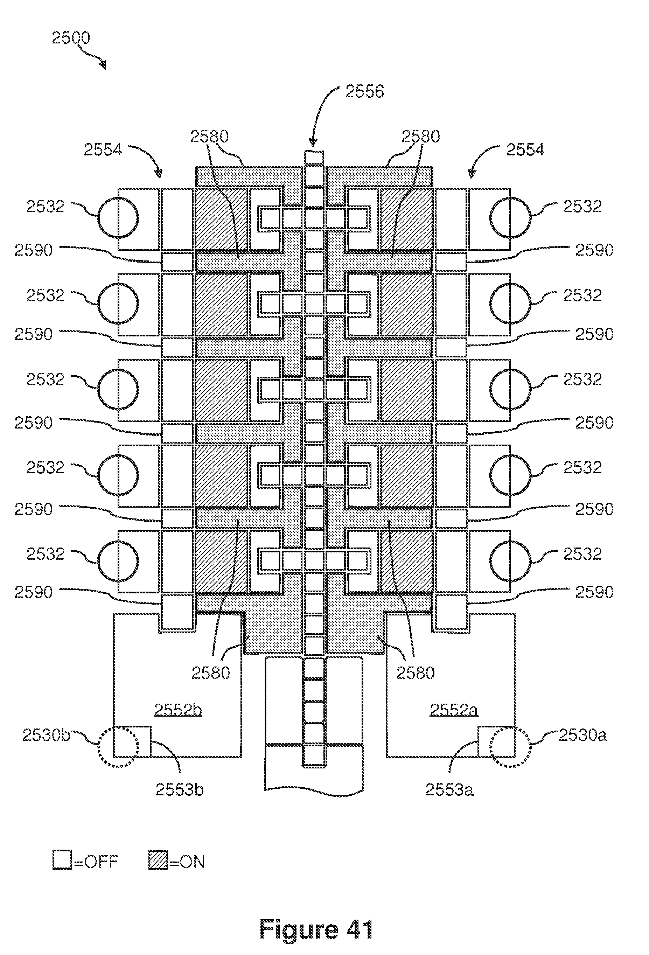

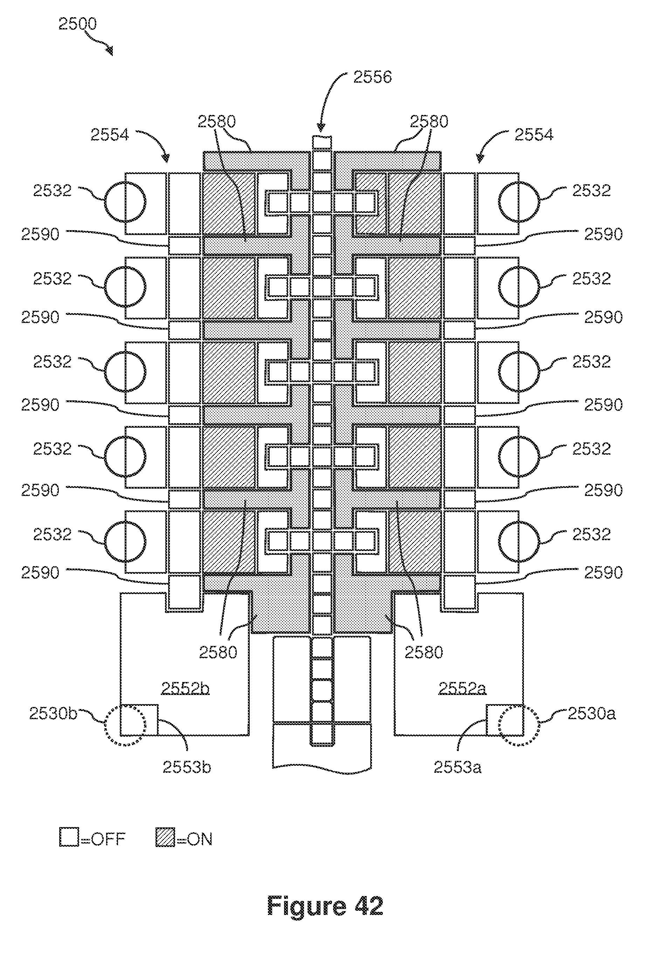

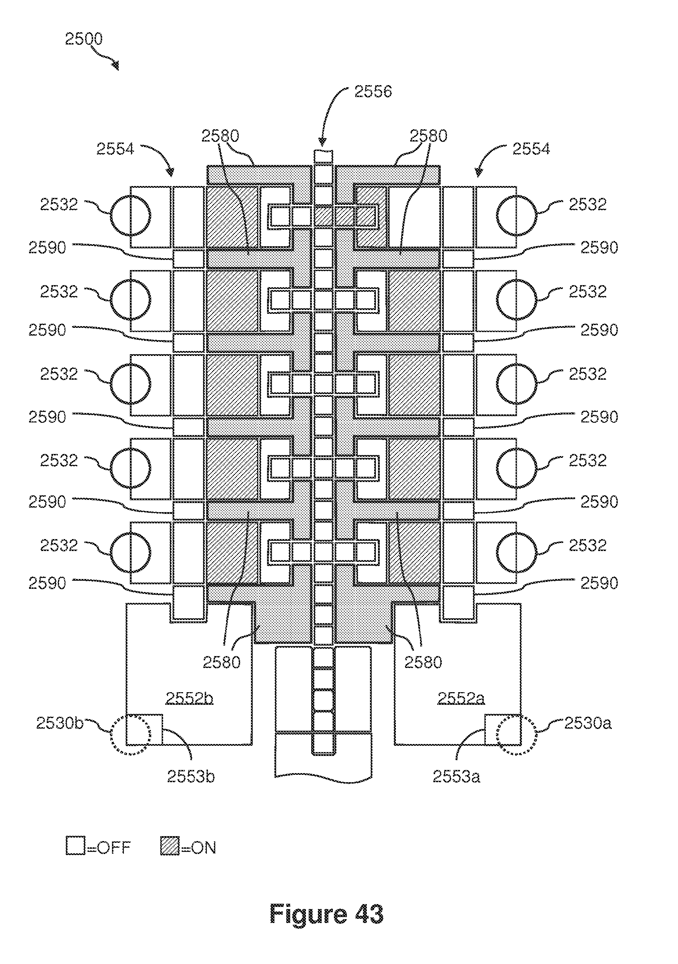

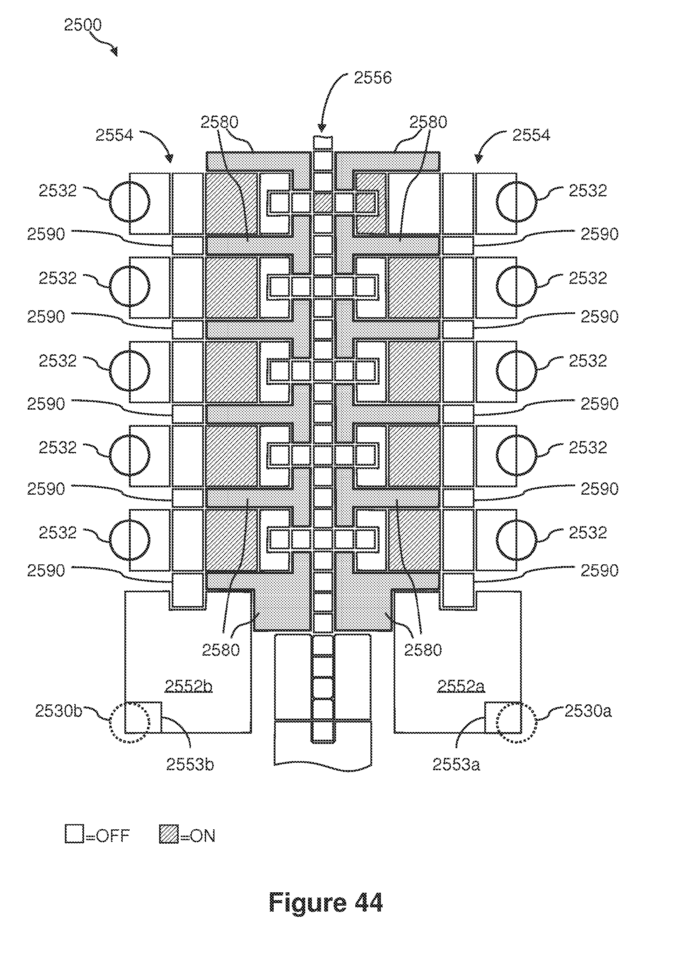

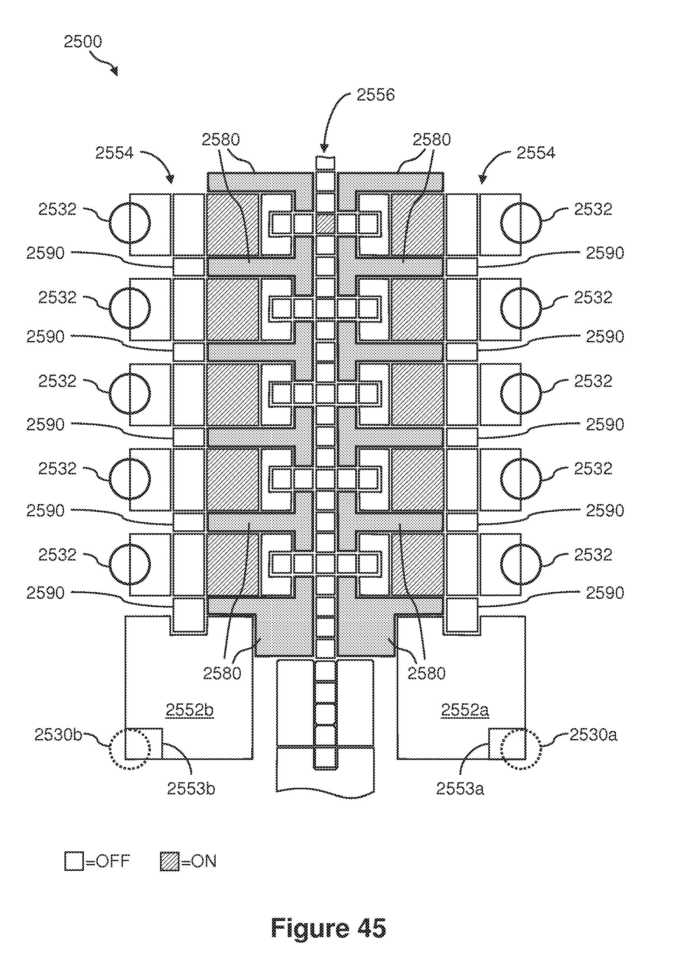

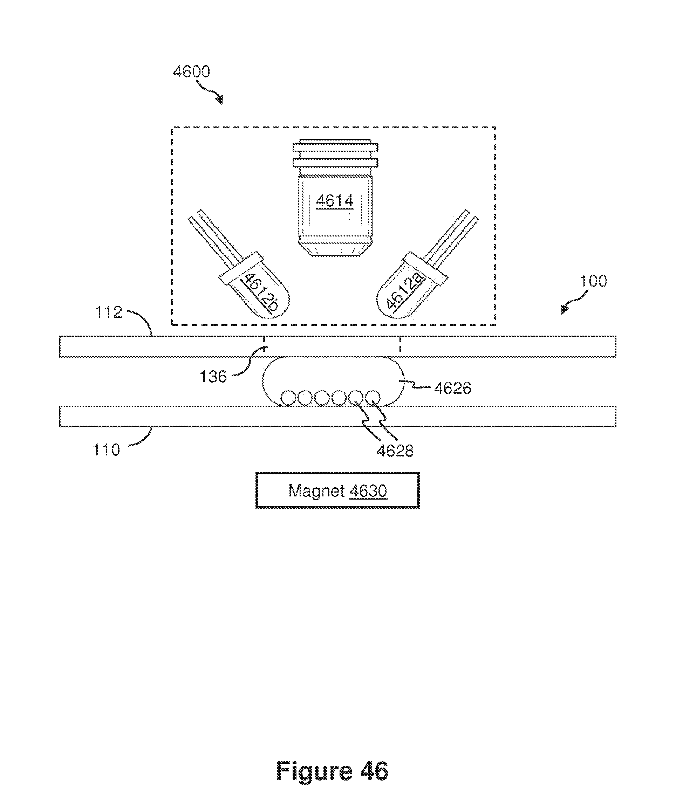

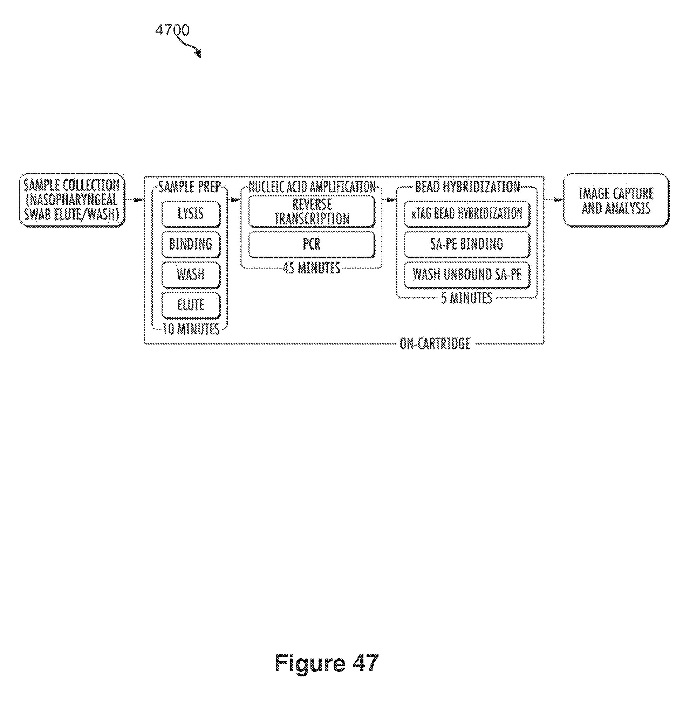

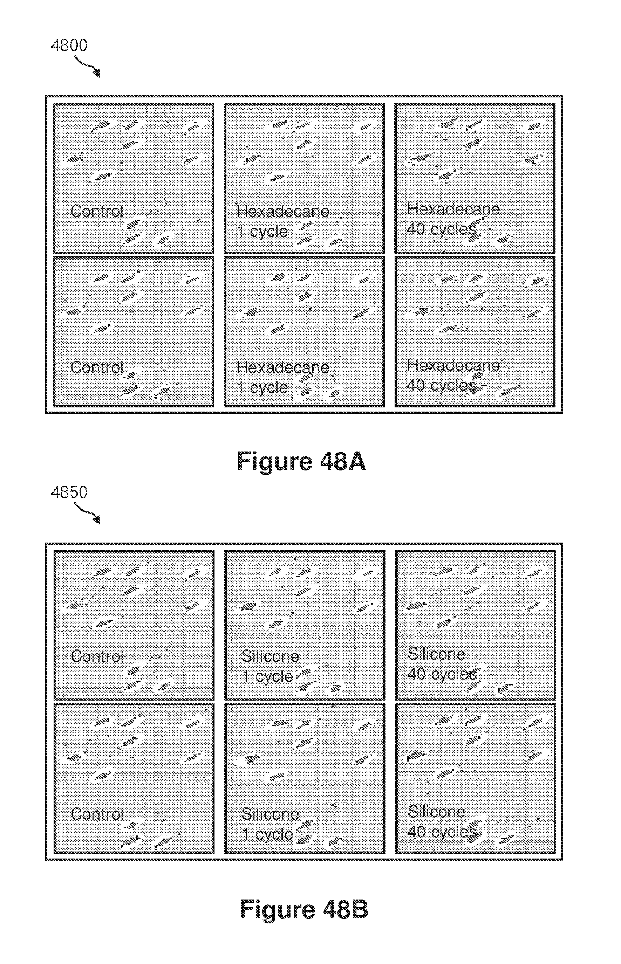

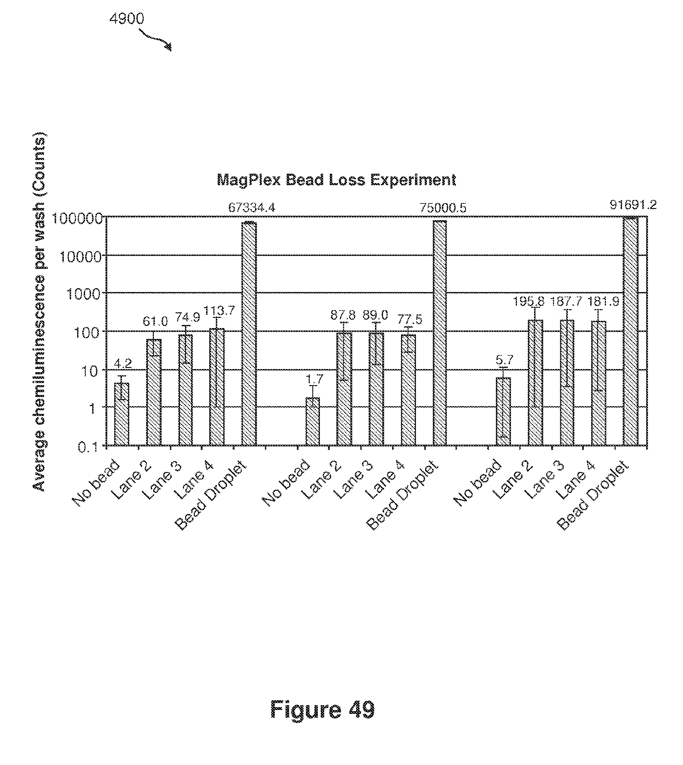

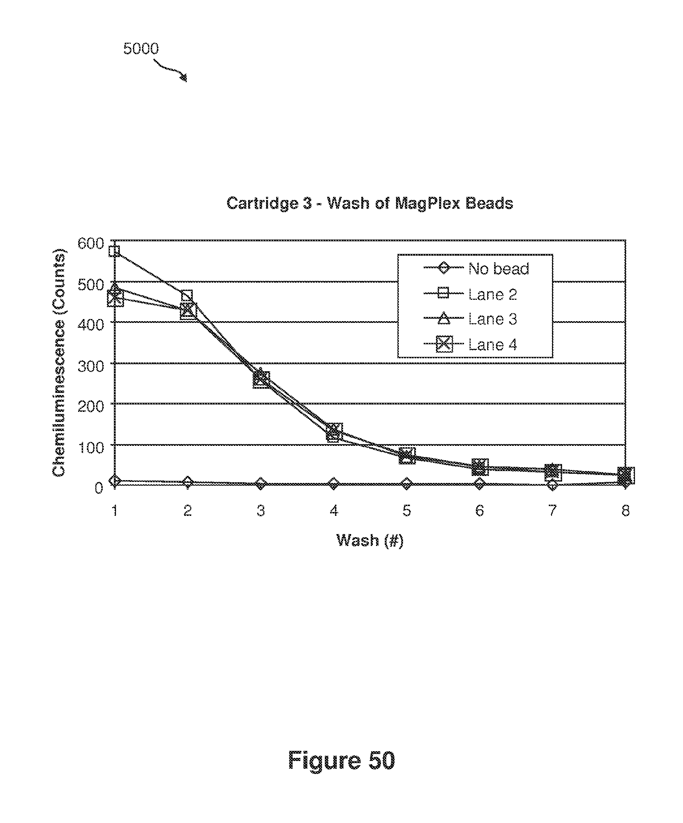

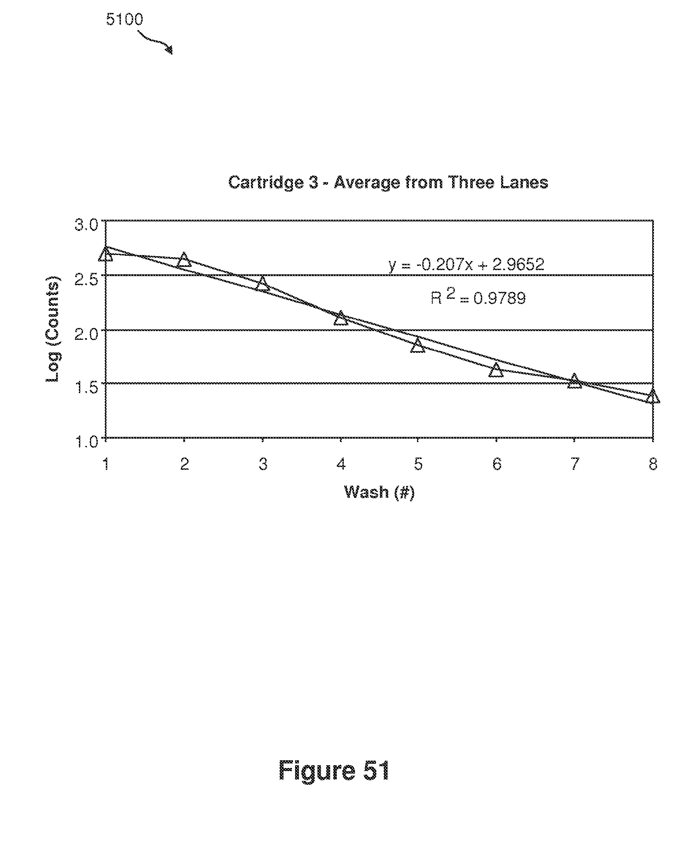

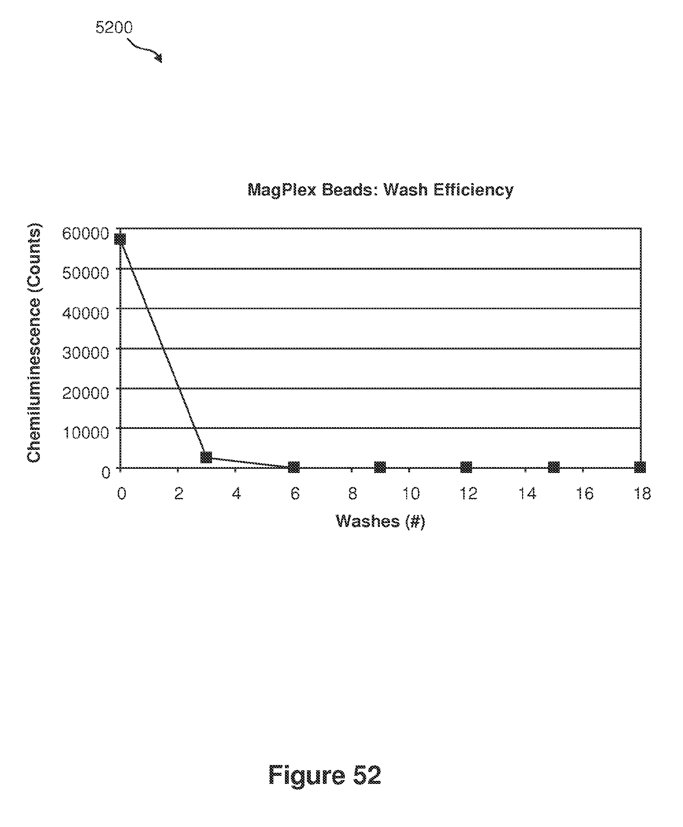

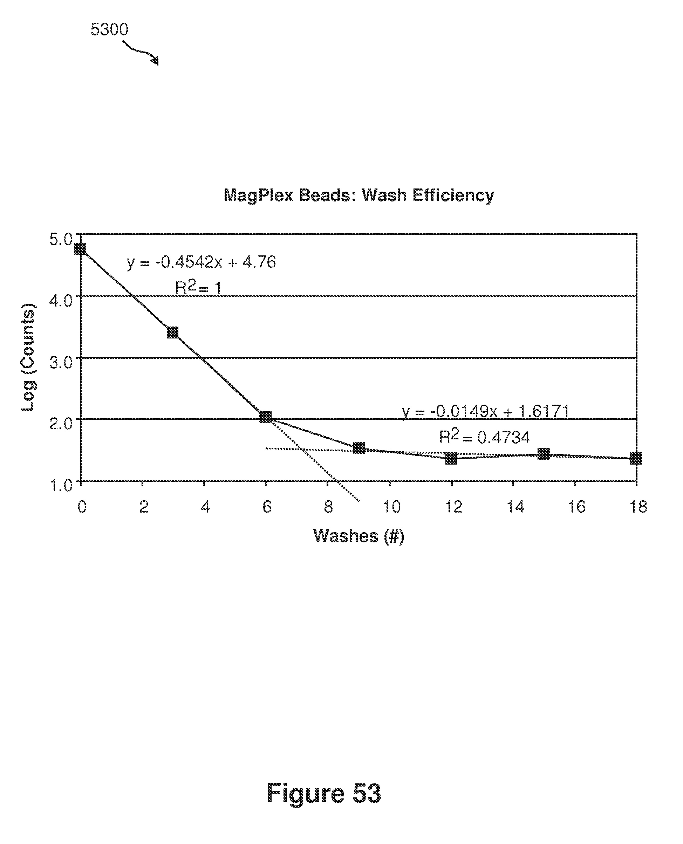

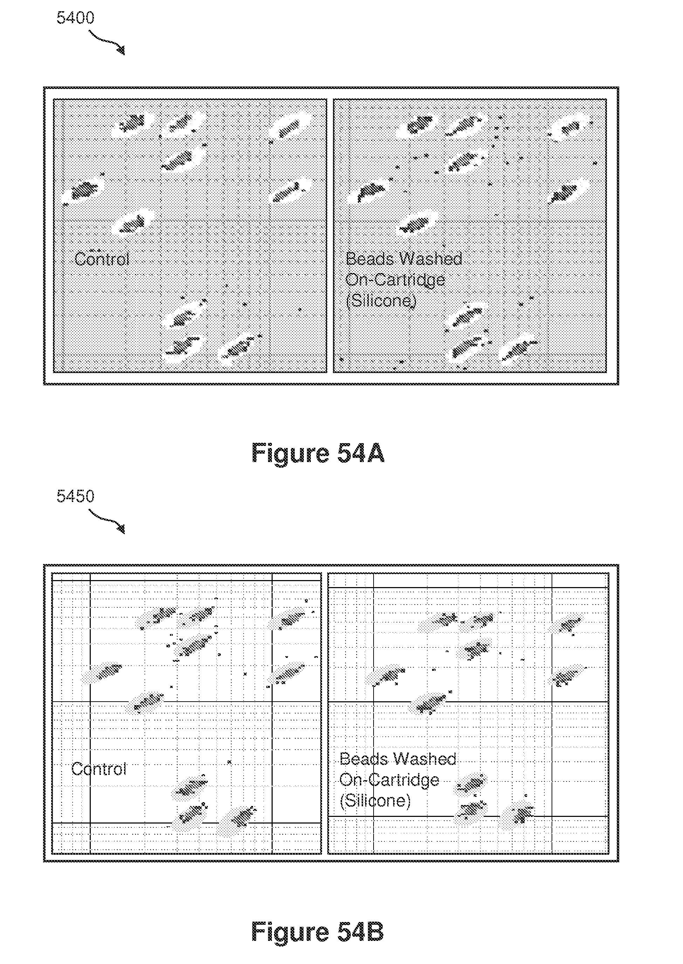

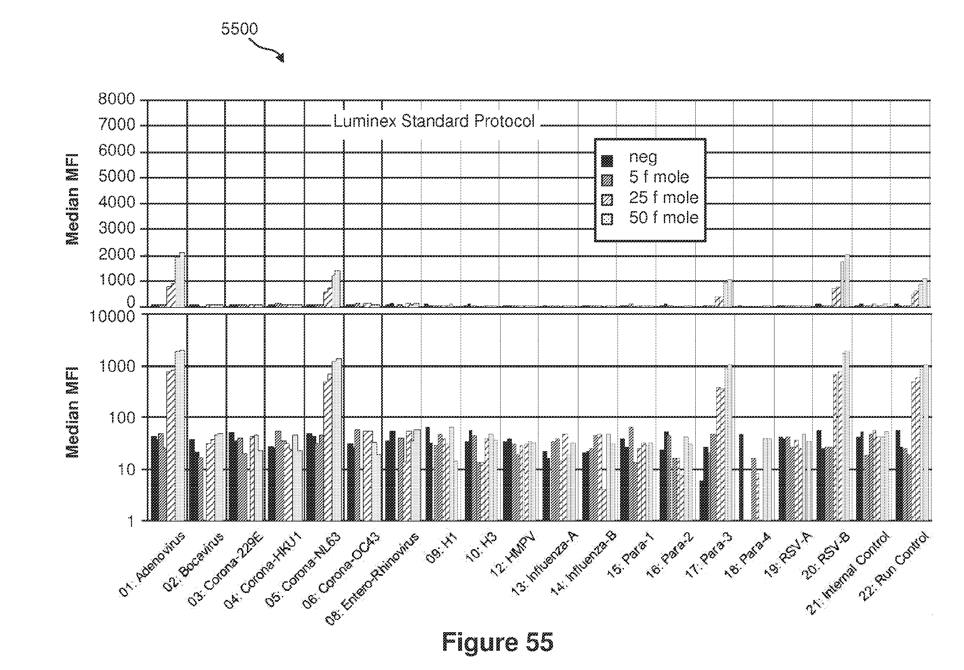

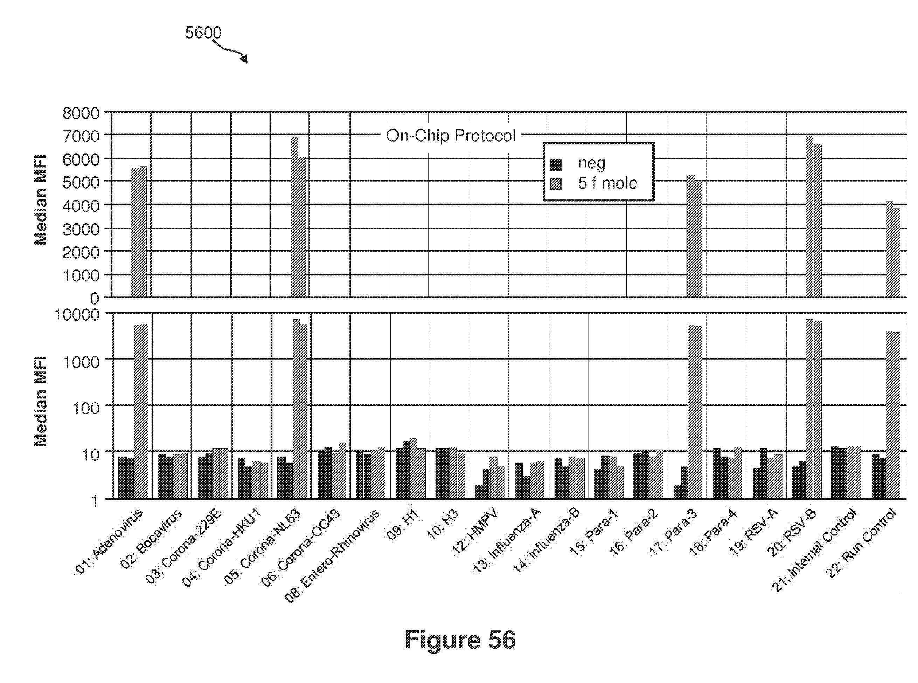

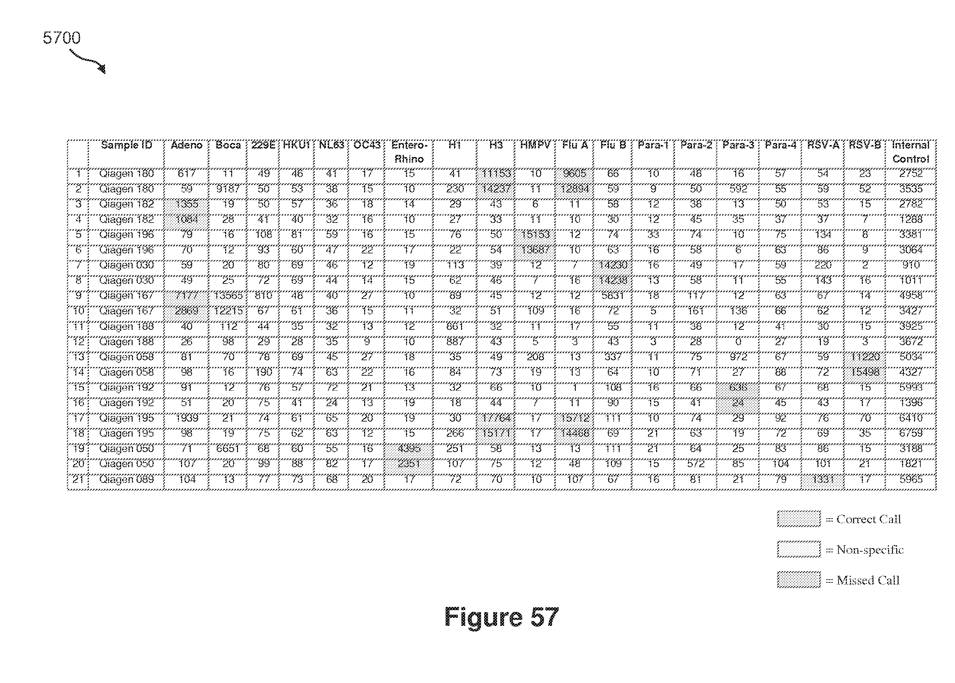

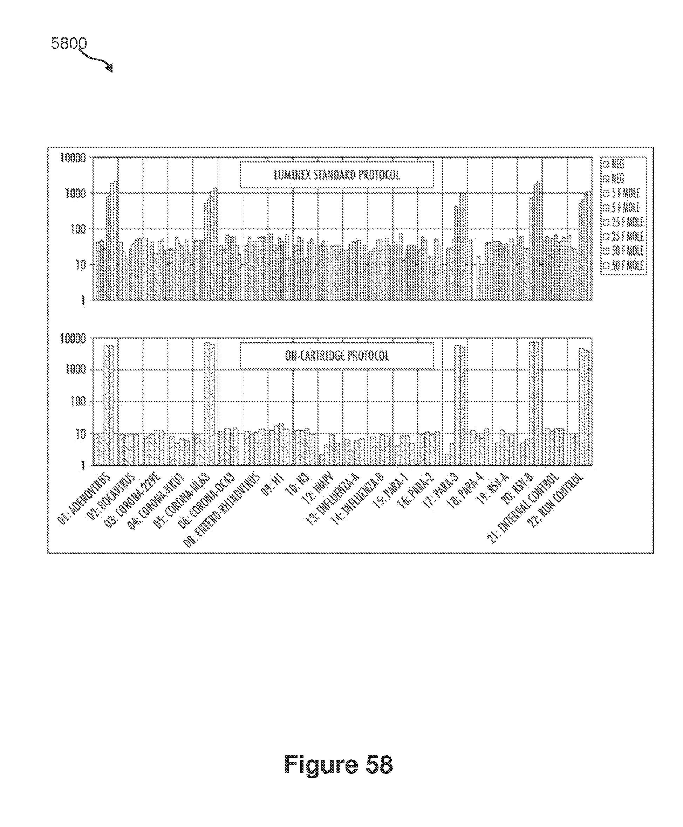

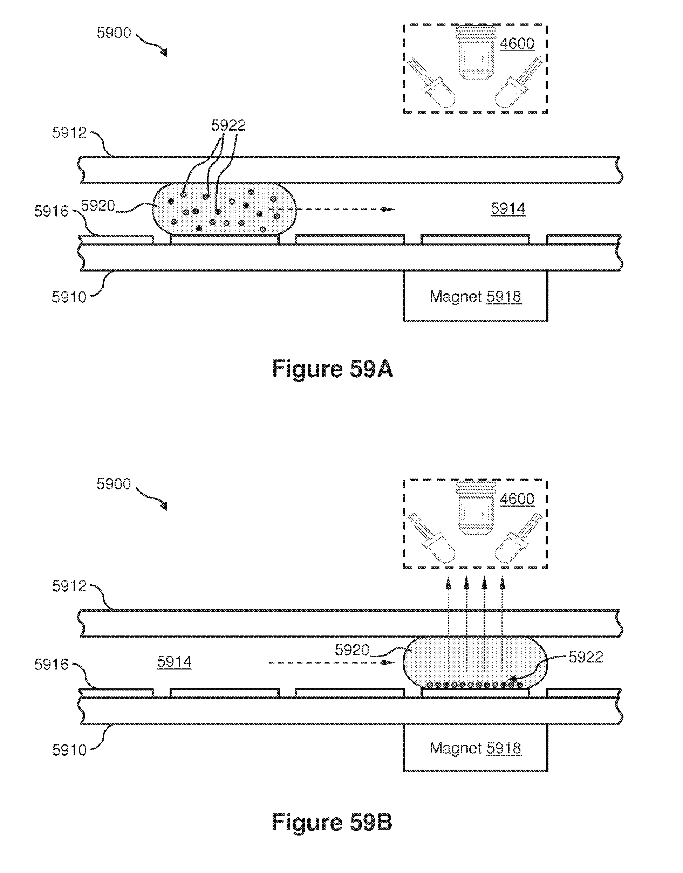

An example of multiplexing an immunoassay in a single droplet that contains different types of beads is described in more detail with reference to Figure 7.

### 6.1.2.1 Detection of Respiratory Viruses

Acute respiratory infections are a leading cause of acute illnesses worldwide and remain the most important cause of infant and young child mortality. Currently, there are several commercially available PCR-based multiplexed respiratory viral panel assays, however most of these are classified as CLIA high complexity, are available only in certain laboratories, and can take more than a day to obtain results. The time-to-result is critical for treatable patients since antiviral medications are effective only within the first 24 hours of infection. Rapid and accurate identification of these pathogens is crucial not only for the treatment of individual patients, but also for the public health by helping to control pandemic infection. In addition, with new variants of respiratory viruses continually emerging, laboratories are now faced with the challenge of detecting as many as 20 different viruses that can cause acute respiratory disease. Some of these respiratory viruses have very specific treatments such as oseltamivir or zanamivir for influenza, Pleconaril for rhinovirus and prophylactic Palivizumab for respiratory syncytial virus (RSV). Infection control practices also differ significantly between viruses and some are reportable to public health authorities.

The device and methods of the invention provide for point-of-care detection of multiple clinically relevant viruses with sufficient sensitivity and specificity to guide therapy and infection control procedures.

In one embodiment, color coded beads (e.g., varying amounts of fluorescent dyes) may be coated with oligonucleotide sequences for capture of specific target DNA sequences (nucleic acid capture beads). In a preferred embodiment, the color coded beads are magnetically responsive beads. Any number of different nucleic acid capture beads may be combined for multiplexed nucleic acid testing of different target sequences in a single sample droplet. One example of magnetically responsive nucleic capture beads suitable for use in a digital microfluidic nucleic acid testing protocol is the xMAP bead microarray (Luminex). xMAP beads (e.g., magnetically responsive MagPlex™ beads) are internally color coded by varying the amount of two fluorescent dyes (e.g., red and infrared) and coated with a reagent (e.g., tagged oligonucleotide sequences) specific to a particular bioassay. A third fluorophore (e.g., phycoerythrin) coupled to a reporter molecule is used to quantify the biomolecular interaction at the bead surface.

In one example, the multiplexed Luminex xTAG respiratory virus panel (RVP), on magnetically responsive MagPlex™ beads, may be adapted for use on a droplet actuator. The xTAG RVP assay may be used to simultaneously detect 19 respiratory virus types or subtypes, including RSV A & B, 4 Corona Viruses (NL63, 229E, OC43, HKU1), SARS, Non-specific Influenza A and H1, H3, H5 subtypes, Influenza B, Parainfluenza 1/2/3/4, Adenovirus Metapneumovirus, Rhinovirus/Enterovirus. The assay also includes two controls, MS-2 Bacteriophage Internal Control and Lambdaphage Positive Control.

Specifications of two examples of the molecular diagnostic platform of the invention are shown in Table 1. In one example, Platform I uses a single sample disposable droplet actuator for integrated sample preparation and multiplexed detection of respiratory viruses using the xTAG RVP assay. In another example, Platform II uses a random access, high throughput droplet actuator for integrated sample preparation (one or more samples) and multiplexed assays of up to 12 different molecular diagnostic panels (e.g., xTAG panels) on a single disposable droplet actuator.

| **Table 1.** Specifications of molecular diagnostics platform | | |
|---|---|---|
| **Product Feature** | **Platform I** | **Platform II** |
| **# parallel tests (use mode)** | 1 | 12 (random access) |
| **CLIA Complexity** | Moderate | Moderate/Waived |
| **Sample prep** | Integrated | Integrated |
| **Tests Offered** | RVP | RVP, other xTAG panels |
| **Plex level possible** | High | High |
| **Time to Result** | <60 min | <30 min |
| **Hands on time** | <5 min | <2 min |
| **Reagent storage** | Loaded by user | Integrated on disposable |

### 6.1.3 Imaging System

The imaging system of the invention is a low cost LED/CCD based bead imaging system. Images may be captured on a computer and analyzed using image processing software. In one example, the imaging system of the invention may be used for multiplexed detection of color coded xMAP beads (e.g., magnetically responsive MagPlex™).

**Figure 3** illustrates a perspective view of an imaging system 300 for multiplexed detection of color coded beads (e.g., fluorescent beads). Imaging system 300 may include one or more LEDs 310, e.g., two LEDs 310a and 310b, and a CCD imager 312. The wavelength of LED 310a may, for example, be 525nm (green). The wavelength of LED 310b may, for example, be 635nm (red). CCD imager 312 may include color filters, e.g., red and green filters. Imaging system 300 may also include an objective lens 314 and a linear actuator 316. Objective lens 314 may be used to magnify or otherwise optically adjust the image. Linear actuator 316 may be used for z-axis focusing of the image.

A droplet actuator 318 may be positioned in proximity to imaging system 300. In particular, droplet actuator 318 may be positioned such that a detection window (not shown) on the droplet actuator is substantially aligned with imaging system 300. Droplet actuator 318 may include a bottom substrate 320 and a top substrate 322 that are separated by a gap 324. A droplet 326 that includes a quantity of magnetically responsive beads 328 may be positioned at a detection spot (not shown) within droplet actuator 318. Magnetically responsive beads 328 may, for example, be color coded fluorescent beads.

Bottom substrate 320 may, for example, be a PCB that includes polymer dielectric and FR4 materials. Because the PCB materials may be a source of autofluorescence, a high optical density material, such as Toray Black Matrix resin (OD=5, T=0.6% at 1um thickness), may be used to coat bottom substrate 320 and substantially eliminate the autofluorescence. In one example, a 5-10 µm coating is sufficient to substantially suppress autofluorescence from the PCB materials. An opaque coating may also have an additional benefit of suppressing reflection and scatter from the metal electrodes (droplet operations electrodes) on bottom substrate 320.

Top substrate 322 may, for example, be formed of a material with low autofluorescence at the imaging wavelengths of interest (525nm and 635nm). In one example, a high temperature PMMA (Acrylite MD H12f) material may be used. Autofluorescence from top substrate 322 may be further reduced by reducing the thickness of the region of top substrate 322 in proximity of a detection window (imaging region). In one example, the thickness of top substrate 322 in proximity of a detection window may be reduced from about 3mm to about 0.5mm.

A magnet 330 may be associated with droplet actuator 318. Magnet 330 may be arranged such that a detection window (not shown) on droplet actuator 318 is within the magnetic field of magnet 330. Magnet 330 may, for example, be a permanent magnet or an electromagnet. In one example, magnet 330 may be a small stationary cube magnet placed about 1.5 inches from the droplet actuator. Magnet 330 may be used, for example, to attract and/or immobilize a quantity of magnetically responsive beads 328 in droplet 326. In operation, magnet 330 may be used to assist in forming a monolayer of magnetically responsive beads suitable for imaging.

In one example, color coded magnetically responsive MagPlex™ beads may be used. In this example, calibration of imaging system 300 may, for example, be performed using MagPlex calibration beads (Luminex Cat no LX200-CAL-K25). Verification of calibration may, for example, be performed using control bead sets (Luminex Cat no LX200-CON-K25). These kits contain xMAP calibrators/controls for MagPlex classification channels (red/infra red) and for the reporter channel (green/phycoerythrin).

The images taken by imaging system 300 of the magnetic beads are two dimensional images that may be described as having a background and bright bead events which comprise the foreground. The background is uniform in theory, but in practice the background is imaged as a slowly varying function. The beads are visualized as small blobs randomly but uniformly positioned on the surface of the background. In the field of image understanding, three hierarchical tasks exist: detection, categorization, and identification, in increasing order of complexity. Detection includes localizing the occurrences of a target object (bead) in the image (in terms of coordinates in the image). Categorization includes determining whether a bead is a bead or is an artifact. Categorization may use information from both red-channel images. Identification uses the relative fluorescence between the two red-channels as a classifier to the identity of a magnetic bead. Once a bead has been categorized and identified, the intensity in the green channel at the same coordinates (or fixed offset) is sampled to evaluate the analyte-based signal (reporter signal). Key criteria will be the resolution of all classes of magnetic beads present in the calibration and control bead mix. Separation and spread of clusters (classes) may be evaluated using well known clustering metrics. Spread of the green-channel intensities (reporter channel) in each cluster may also be well-characterized using standard deviation and other dispersion metrics.

### 6.2 Respiratory Virus Detection Protocol

Respiratory viruses are typically detected using nasopharyngeal swabs or nasopharyngeal wash as the collected sample and nucleic acid testing as the assay method. In one example, the swabs are stored and transported in tubes containing 1 mL of viral transport buffer. For sensitive detection, it is preferable to use as much of the sample as possible.

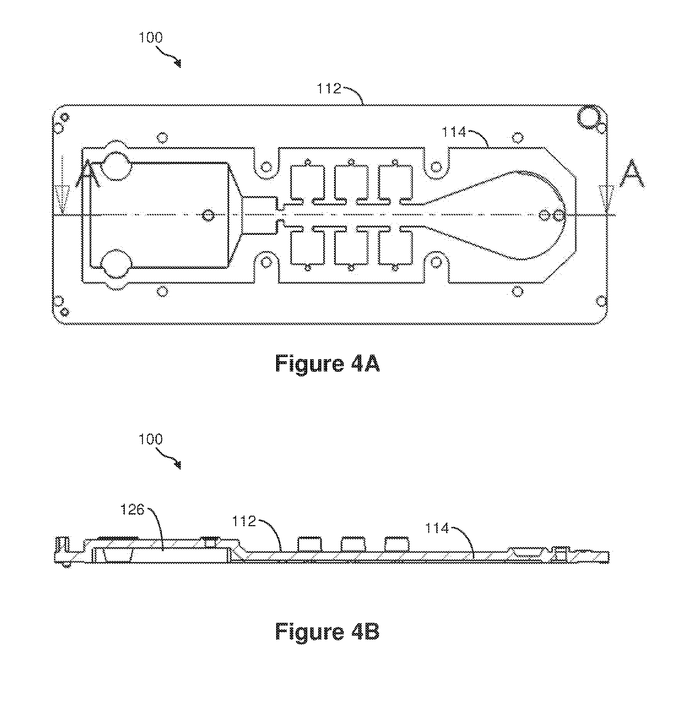

**Figure 4** illustrates a flow diagram of an example of a protocol 400 for sample-to-answer detection of respiratory viruses in a biological sample. Protocol 400 integrates sample preparation (e.g., purification of viral nucleic acid), nucleic acid amplification, and bead hybridization on a single droplet actuator. In one example, protocol 400 uses xTAG RVP primers and beads for detection of respiratory viruses in a clinical sample. Protocol 400 may include, but is not limited to, the following steps.

In one step, a nasopharyngeal swab or nasopharyngeal wash sample (e.g., about 1 mL) is collected and placed into a sample input reservoir on a droplet actuator. Sample preparation reagents, e.g., lysis reagent and magnetically responsive RNA capture beads are placed into a reagent input reservoir on the droplet actuator. In one example, Dynabeads SILANE viral kit (Life Technologies) may be used for nucleic acid preparation.

In other steps, viral RNA is prepared. The nasopharyngeal sample is mixed with lysis reagent to disrupt the viral protein coat and release the nucleic acid. Sample processing on-chip captures viral RNA from the nasopharyngeal sample onto magnetically responsive beads. The magnetically responsive beads with bound RNA thereon are washed extensively to remove all unbound material. The RNA is eluted from the magnetically responsive beads. Preparation of viral RNA may, for example, be completed in about 10 minutes.

In other steps, nucleic acid amplification is performed. Purified viral RNA is reverse transcribed into cDNA and subsequently amplified by PCR. The amplified DNA is mixed with short sequences of DNA specific to each viral target (target specific primer). The target specific primer may be tagged with a universal tag sequence that is common to all primers. If the viral target sequence is present in the sample, the primer will bind and will be extended (target specific primer extension; TSPE). In one example, each target specific primer in the primer extension reaction is attached to an xTAG universal tag sequence (TAG primer). Nucleic acid amplification may, for example, be completed in about 45 minutes.

In other steps, a droplet analyte capture beads (e.g., xTAG beads) is dispensed onto the droplet actuator. Attached to each analyte capture bead is an anti-tag sequence. In the example using TAG primer sequences, attached to each differently colored xTAG bead is an anti-TAG sequence specific to one of the extended TAG primers. The droplet of analyte capture beads (e.g., xTAG beads) is combined using droplet operations with a droplet of amplified DNA. Following a period of time sufficient for hybridization of analyte capture beads to target DNA, a droplet of reporter dye (e.g., SA-PE) is dispensed and combined with the hybridization reaction. After a period of time sufficient for reporter binding, the magnetically responsive capture beads with target/reporter complexes (e.g., TAG/anti-TAG/reporter complexes) thereon are washed extensively to remove all unbound material.

In another step, images of analyte capture beads and reporter complexes are captured on a computer and analyzed using custom image processing software.

**Figure 5** illustrates a top view of droplet actuator 110 of Figure 1 and illustrates an example of droplet actuator architecture suitable for performing the respiratory virus detection protocol 400 of Figure 4. In one embodiment, sample preparation reagents (e.g., lysis buffer, RNA capture beads, elution buffer) and assay reagents (e.g., RT-PCR reagents, analyte capture beads, reporter dye) may be manually loaded onto droplet actuator 110 by a user. In another embodiment, sample preparation reagents and assay reagents may be pre-loaded and stored on droplet actuator 110 prior to use. Pre-loading of droplet actuator 110 with sample preparation and assay components provides a ready-to-use device that minimizes hands-on time during operation.

Sample dispensing reservoir 118 is aligned with an arrangement of sample dispensing electrodes 510 and sample preparation electrodes 511. Reagent dispensing reservoirs 120 are aligned with corresponding reagent dispensing electrodes 512, i.e., dispensing electrodes 512a through 512f. Sample dispensing electrodes 510 and reagent dispensing electrodes 512 are interconnected through an arrangement, such as a path or array, of droplet operations electrodes 514 (e.g., electrowetting electrodes).

In operation, a larger volume of sample fluid (e.g., a nasopharyngeal swab elute of about 1 mL) is loaded into sample dispensing reservoir 118 through sample input port 122. A volume, e.g., about 0.5 mL, of sample preparation reagent (e.g., lysis buffer, RNA capture beads) is loaded into sample dispensing reservoir 118 through reagent input port 124. In one example, reagent dispensing reservoir 120a may contain a quantity of RT-PCR reagent fluid. Reagent dispensing reservoirs 120b and 120c may contain a quantity of wash buffer fluid. Reagent dispensing reservoir 120d may contain a quantity of analyte capture beads suspended in a buffer fluid. Reagent dispensing reservoir 120e may contain a quantity of reporter dye (e.g., SA-PE). Reagent dispensing reservoir 120f may contain a quantity of nucleic acid elution buffer.

### 6.2.1 Sample Preparation

On-bench protocols for preparation of viral RNA may be described and implemented on a droplet actuator as discrete step-by-step droplet-based protocols. Some modifications to existing assay protocols facilitate translation of the bench-based protocols into droplet-based protocols. In one embodiment, Dynabeads SILANE viral kit (Life Technologies) for viral nucleic acid preparation may be adapted for use on a droplet actuator. Examples of steps and parameters in a sample preparation protocol that may be adapted in a digital microfluidic protocol are shown in Table 2.

| **Table 2.** Selection of sample preparation protocol | | | |
|---|---|---|---|
| **Step** | **Cartridge protocol** | **Objective** | **Key experiments** |
| **Lysis** | Mix lysis buffer, sample in input reservoir. | ↑ Lysis efficiency | Optimize volumes of lysis buffer, sample and lysis time. Increase temperature to decrease lysis time. |
| | | ↓ Lysis time | |
| **Binding** | Mix lysed sample with magnetic beads. | ↑ Capture efficiency | Optimize bead concentration. Increase bead concentrations to decrease binding time. |
| | | ↓ Binding time | |
| **Bead capture** | Concentrate beads after binding step into 0.5uL droplet. | ↓ Bead loss | Optimize position and strength of magnet to rapidly concentrate beads from 1mL into 0.5uL droplet. |
| | | ↓ Concentration time | |
| **Wash** | Wash concentrated beads using standard protocols. | ↓Inhibition | Optimize washing protocol. Increase number of wash cycles to remove inhibitors. |
| | | ↓Bead loss | |
| **Elute** | Mixing with elution buffer and split supernatant free of beads. | ↑Elution efficiency. | Optimize mixing time and splitting protocol to recover maximum volume of eluent. Increase temperature to increase elution efficiency. |

In another embodiment, an influenza A model system (Zeptometric) and quantitative RT-PCR may be used for selection of microfluidic and magnetic bead handling protocols.

In yet another embodiment, different respiratory viral controls (Zeptometrix) spiked in Copan Universal Transport Media may be used as control samples for preparation of viral RNA on a droplet actuator.

### 6.2.2 Digital Microfluidic RT-PCR Protocol

On-bench protocols for reverse transcription (RT) of viral RNA and PCR amplification of cDNA may be described and implemented on a droplet actuator as discrete step-by-step droplet-based protocols. Some modifications to existing assay protocols facilitate translation of the bench-based protocols into droplet-based protocols. Assay protocols may, for example, be selected for increased sensitivity and rapid time-to-result. In one example, control RNA samples extracted using bench-based protocols may be used to select reverse transcription and PCR amplification protocols. An example of a comparison of on-bench and on-chip RT-PCR assays is shown in Table 3. Both on-bench and on-chip assays were performed using the Roche Transcriptor 1-step RT-PCR kit.

| **Table 3.** On-bench kit vs on-chip protocol for RT-PCR | | |
|---|---|---|
| **Step** | **Kit protocol** | **On-chip protocol** |
| **Reverse transcription** | 5 min @50C | 10 min @50C |
| **Initial denaturation** | 5 min @94C | 2 min @94C |
| **PCR - Denaturation + Annealing + Elongation** | (10+30+60 sec) x 40 = 66 min | (10+15+15 sec) x 40 = 26 min |
| **Final elongation** | 5 min | 5 min |
| **Total time** | **81 min** | **43 min** |

In another example, 40 cycles of PCR performed on-chip may be completed in less than about 30 minutes.

### 6.2.3 Digital Microfluidic Bead Hybridization and Detection Protocol

On-bench protocols for analyte capture bead hybridization and reporter labeling may be described and implemented on a droplet actuator as discrete step-by-step droplet-based protocols. Some modifications to existing assay protocols facilitate translation of the bench-based protocols into droplet-based protocols. In one embodiment, on-bench processed viral RNA control samples may be used to select appropriate on-chip reaction parameters (e.g., hybridization, reporter labeling). An imaging system, such as the imaging system described in reference to Figure 3, may be used for detection. In one example, on-bench protocols for xTAG bead hybridization and reporter labeling may be described and implemented on a droplet actuator.

### 6.2.4 Integration of Sample Preparation and xTAG RVP Assay

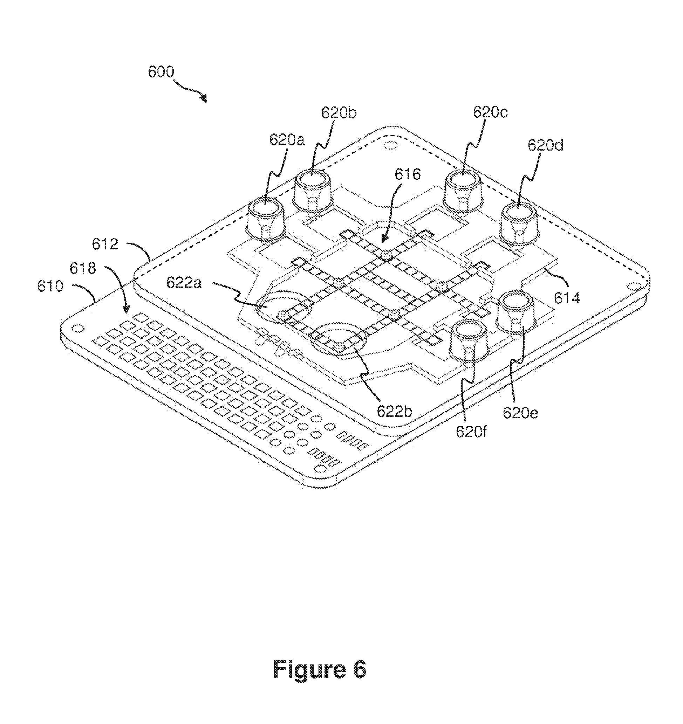

The invention provides methods for integrated sample preparation (i.e., nucleic acid isolation and amplification) and detection (e.g., xTAG spectral multiplexing) of respiratory viruses on a droplet actuator. **Figure 6** shows a bar graph 600 of a comparison of an xTAG RVP assay performed on-bench and on a droplet actuator. Viral RNA was extracted on-bench. RT-PCR, xTAG bead hybridization and reporter labeling steps were performed on-chip, followed by detection on a Luminex LX100 flow cytometer (bottom graph On-Cartridge Protocol). In parallel, the experiment was performed using the standard Luminex xTAG assay protocol (top graph Luminex Standard Protocol). Assays performed on-chip and using the standard Luminex xTAG protocol are comparable. Sensitivity of the xTAG assay was higher on-chip compared to the standard protocol.

### 6.3 Multiplexing Immunoassays

The invention also provides a method of multiplexing immunoassays in a droplet actuator using a single droplet that contains multiple types of beads. In existing droplet actuators, the ability to multiplex immunoassays is a time consuming process that requires intensive attention by a skilled technician. Existing methods of multiplexing immunoassays require that the sample be divided into multiple volumes and that beads be separated and processed individually. By contrast, the method of multiplexing immunoassays of the invention uses a single sample droplet that contains different types of beads, the types and numbers of which are determined beforehand.

**Figures 7A and 7B** illustrate a side view of a portion an example of a droplet actuator 700 and illustrate a process of multiplexing immunoassays using multiple types of beads in a single droplet. Droplet actuator 700 may include bottom substrate 710 that is separated from a top substrate 712 by a gap 714. Bottom substrate 710 may include an arrangement of droplet operation electrodes 716 (e.g., electrowetting electrodes). Droplet operations are conducted atop droplet operations electrodes 716 on a droplet operations surface. A magnet 718 may be arranged in close proximity to bottom substrate 710 and substantially aligned with a certain electrode 716, such that the certain electrode 716 is within the magnetic field of magnet 718. Magnet 718 may be a permanent magnet or an electromagnet. Magnet 718 may in some embodiments be sized to substantially correspond to the footprint of the certain electrode 716.

The gap between bottom substrate 710 and top substrate 712 of droplet actuator 700 may contain a droplet 720. Droplet 720 may, for example, be a droplet of sample fluid or a reagent fluid. A plurality of beads 722 to be evaluated may be suspended in droplet 720. Beads 722 may, for example, be a combination of one or more types of beads. That is, beads 722 may be a collection of different types of beads that have affinities for different analytes or substances, e.g., different primary capture antibodies having affinity for different substances. Additionally, beads 722 may be magnetically responsive. Examples of suitable magnetically responsive beads are described in U.S. Patent 7,205,160, entitled, "Multiplex flow assays preferably with magnetic particles as solid phase," granted on April 17, 2007.

In one example, beads 722 may contain a certain number of a first type of magnetic bead that has a first type of primary capture antibody, a certain number of a second type of magnetic bead that has a second type of primary capture antibody, a certain number of a third type of magnetic bead that has a third type of primary capture antibody, and so on. Additionally, each type of bead has an identifying trait for easily differentiating one type of bead from another. For example, the various types of beads 722 may be differentiated by color, fluorescence, size, density, surface properties, responsiveness to a magnetic field, radioactivity, and any combinations thereof. In some embodiments, the number of each type of bead 722 within droplet 720 is known.

Upon interacting with a reagent, the different types of beads 722 within droplet 720 may be evaluated for target substances that have an affinity for the beads. As an example, a method of evaluation may involve digital imaging of the beads for identifying, for example, different fluorophores. In this embodiment, an imaging device 724 may be associated with droplet actuator 700. Imaging device 724 may be used to capture digital images of, for example, droplet 720 and the beads 722 therein. Imaging device 724 may capture images through top substrate 712, which may be, for example, a glass plate that is substantially transparent or otherwise transmissive of wavelengths of interest. Various filters may be used to distinguish beads by wavelengths emitted and/or the invention may employ a spectrometer that can image different wavelengths. Imaging device 722 may be any image capture device, such as, but not limited to, any suitable CMOS image sensor, charge-coupled device (CCD), photodiode arrays, and/or digital camera. By use of imaging device 724 and the multiple types of beads 722 within droplet 720, a mechanism is provided for performing multiple immunoassays using a single droplet, i.e., multiplexing immunoassays, which is the process of evaluating a single sample that includes multiple substances of interest.

A method of multiplexing immunoassays using a single droplet that contains multiple types of beads may be accomplished using any of a variety of droplet operations mediated by electrodes 716. A droplet including the beads and potentially including one or more target molecules may be provided on the droplet actuator. For example, a droplet including the beads may be combined with a droplet including the one or more target molecules using droplet operations on the droplet actuator. Or, as another example, the beads may be brought into association with a fluid comprising the target molecules off the droplet actuator, and thereafter introduced onto the droplet actuator. The beads in association with the target molecules may be subjected to various immunoassay protocols, such as a sandwich immunoassay protocol. For example, a first type of substance may bind to the first type of primary capture antibody of the first type of magnetic bead, a second type of substance may bind to the second type of primary capture antibody of the second type of magnetic bead, a third type of substance may bind to the third type of primary capture antibody of the third type of magnetic bead, and so on.

At a certain point in the immunoassay protocol when imaging is desired, beads 722 may be transported into proximity with magnet 718, as illustrated in Figure 7B. Because beads 722 are magnetically responsive, a layer of beads 722 form along the surface of the droplet operations electrode 716. Preferably, the concentration of beads 722 within droplet 720 is substantially optimized such that the layer of beads 722 is substantially a monolayer, with substantially no clumping. The optimization to provide a monolayer of beads may occur by selecting a certain size of bead, certain gap height, certain magnetic field strength, certain magnetic field pattern, and/or using various additives such as surfactants to control surface tension of the droplet. For example, providing large beads and a small gap may assist in the formation of a monolayer of beads. Droplet 720 may then be illuminated, and a digital image of the monolayer of beads 722, as shown in Figure 7B, may be captured via imaging device 724.

Using image analysis techniques, each type of bead 722 may be identified via its predetermined identifying trait (e.g., color, fluorescence, and/or size). In another embodiment, each type of bead 722 may be identified by measuring its magnetism level using a Superconducting QUantum Interference Device (SQUID) magnetometer (not shown). Subsequently, once identified, each type of bead 722 may be evaluated for additional substances, such as for secondary antibodies of interest that may be bound thereto. For example, this may be accomplished by evaluating the type of fluorophore that is attached to each type of bead 722. More specifically, a secondary antibody may be labeled with a fluorophore. Once exposed to the reagent, imaging may be used to quantify the amount of secondary antibody that has been captured.

A variation of the method of multiplexing immunoassays using a single droplet that contains multiple types of beads may include imaging the beads before exposing the beads to target analytes, in order to indentify the location of each bead. Then the beads may be subjected to an immunoassay protocol while maintaining their position, after which the beads may be reimaged in order to identify the expected properties of each bead resulting from the immunoassay, e.g., the measure the fluorescence from each bead, and/or, a change in fluorescence resulting from the immunoassay protocol.

In various embodiments, filters may be used to assist in the differentiation of beads having different fluorophores. Multiple filters may be required, for example, to distinguish the fluorescence of the primary antibody of the bead from the fluorescence of the secondary antibody.

An aspect of the invention is the use of different types of beads and determining beforehand the number and type of each bead in the sample droplet. Because the number, types and/or locations of bead are known, the fluorescence, luminescence, radioactivity, or other reporter characteristics can be used to distinguish multiple substances in a single droplet.

### 6.4 Systems

Referring to Figures 1 through 7B, it will be appreciated that various aspects of the invention may be embodied as a method, system, or computer program product. Aspects of the invention may take the form of hardware embodiments, software embodiments (including firmware, resident software, micro-code, etc.), or embodiments combining software and hardware aspects that may all generally be referred to herein as a "circuit," "module" or "system." Furthermore, the methods of the invention may take the form of a computer program product on a computer-usable storage medium having computer-usable program code embodied in the medium.

Any suitable computer useable medium may be utilized for software aspects of the invention. The computer-usable or computer-readable medium may be, for example but not limited to, an electronic, magnetic, optical, electromagnetic, infrared, or semiconductor system, apparatus, device, or propagation medium. More specific examples (a non-exhaustive list) of the computer-readable medium would include some or all of the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a transmission medium such as those supporting the Internet or an intranet, or a magnetic storage device. Note that the computer-usable or computer-readable medium could even be paper or another suitable medium upon which the program is printed, as the program can be electronically captured, via, for instance, optical scanning of the paper or other medium, then compiled, interpreted, or otherwise processed in a suitable manner, if necessary, and then stored in a computer memory. In the context of this document, a computer-usable or computer-readable medium may be any medium that can contain, store, communicate, propagate, or transport the program for use by or in connection with the instruction execution system, apparatus, or device.

Computer program code for carrying out operations of the invention may be written in an object oriented programming language such as Java, Smalltalk, C++ or the like. However, the computer program code for carrying out operations of the invention may also be written in conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through a local area network (LAN) or a wide area network (WAN), or the connection may be made to an external computer (for example, through the Internet using an Internet Service Provider).

Certain aspects of invention are described with reference to various methods and method steps. It will be understood that each method step can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the methods.

The computer program instructions may also be stored in a computer-readable memory that can direct a computer or other programmable data processing apparatus to function in a particular manner, such that the instructions stored in the computer-readable memory produce an article of manufacture including instruction means which implement various aspects of the method steps.

The computer program instructions may also be loaded onto a computer or other programmable data processing apparatus to cause a series of operational steps to be performed on the computer or other programmable apparatus to produce a computer implemented process such that the instructions which execute on the computer or other programmable apparatus provide steps for implementing various functions/acts specified in the methods of the invention.

### 7 Concluding Remarks

The foregoing detailed description of embodiments refers to the accompanying drawings, which illustrate specific embodiments of the invention. Other embodiments having different structures and operations do not depart from the scope of the present invention. The term "the invention" or the like is used with reference to certain specific examples of the many alternative aspects or embodiments of the applicants' invention set forth in this specification, and neither its use nor its absence is intended to limit the scope of the applicants' invention or the scope of the claims. This specification is divided into sections for the convenience of the reader only. Headings should not be construed as limiting of the scope of the invention. The definitions are intended as a part of the description of the invention. It will be understood that various details of the present invention may be changed without departing from the scope of the present invention. Furthermore, the foregoing description is for the purpose of illustration only, and not for the purpose of limitation.

The present application is a divisional application based on an earlier European Application No 12779928.6, which was in turn derived from PCT Application No PCT/US2012/035963. The following numbered clauses 1 to 44, which correspond to the claims of that earlier PCT Application as filed, form part of the present disclosure and in particular form further aspects of the invention, whether or not they appear in the present claims.

### Clauses 1 to 44

1. A method of mixing a droplet, the method comprising:
   (a) providing a droplet on a surface;
   (b) forming the droplet into a first "U" shape having a bottom region and two terminal ends;
   (c) simultaneously merging the terminal ends and splitting the droplet at the bottom region to form a second "U" shape which is substantially opposite the first "U" shape.
2. The method of clause 1 comprising repeating steps (b) and (c) one or more times.
3. The method any of clauses 1 and following, wherein the forming step comprises manipulating the droplet using droplet operations mediated by electrodes.
4. The method any of clauses 3 and following, wherein the droplet operations are electrowetting-mediated.
5. The method any of clauses 1 and following, wherein the droplet comprises beads.
6. The method any of clauses 1 and following, wherein the droplet comprises a sample.
7. The method any of clauses 1 and following, wherein the providing step comprises merging a sample droplet and a reagent droplet to yield the droplet on the surface.
8. The method any of clauses 1 and following, wherein the droplet is situated on the surface and sandwiched between two substrates.
9. A droplet actuator comprising:
   (a) a first substrate having a flat surface;
   (b) a second substrate separated from the first substrate to form a droplet operations gap;
   (c) an opening in the second substrate forming a fluid path from an external locus of the droplet actuator into the droplet operations gap;
   (d) a dried reagent pellet having a flat surface situated on the first substrate and aligned with the opening, wherein the flat surface of the dried reagent pellet abuts the flat surface of the first substrate.
10. The droplet actuator of any of clauses 9 and following, further comprising an electrode underlying the dried reagent pellet.
11. The droplet actuator of any of clauses 10 and following, wherein the electrode has a shape which is substantially similar to the shape of the flat surface of the dried reagent pellet.
12. The droplet actuator of any of clauses 9 and following, wherein the dried reagent pellet has a shape which is selected from the group consisting of: substantially cone shaped; substantially cone shaped with a rounded point; substantially cylindrical; substantially cylindrical with a rounded end; substantially hemispherical; substantially ovoidal; geometric sections of any of the foregoing.
13. The droplet actuator of any of clauses 9 and following, wherein the opening has a central axis, the dried reagent pellet has a central axis, and the central axis of the dried reagent pellet is substantially aligned with the central axis of the opening.
14. The droplet actuator of any of clauses 9 and following, wherein the dried reagent pellet has a height which is greater than the height of the droplet operations gap.
15. A method of providing a reagent on a droplet actuator, the method comprising:
   (a) providing the droplet actuator of any of clauses 9 and following; and
   (b) flowing liquid through the opening into contact with the dried reagent pellet, thereby dissolving the dried reagent pellet in the liquid to provide a reagent droplet.
16. The method of any of clauses 15 and following, wherein the liquid comprises a sample.
17. The method of any of clauses 15 and following, wherein the liquid comprises a buffer.
18. A droplet actuator comprising:
   (a) one or more substrates arranged to form a droplet operations gap;
   (b) an arrangement of electrodes associated with one or both substrates, the electrodes comprising:
      (i) a central path of electrodes;
      (ii) flanking electrodes arranged on either side of the central path of electrodes.
19. The droplet actuator of any of clauses 18 and following, wherein each central electrode is aligned with a pair of flanking electrodes.
20. The droplet actuator of any of clauses 18 and following, wherein each set two central electrodes is aligned with a single pair of flanking electrodes.
21. The droplet actuator of any of clauses 18 and following, wherein each set three central electrodes is aligned with a single pair of flanking electrodes.
22. The droplet actuator of any of clauses 18 and following, wherein the electrodes comprise electrowetting electrodes.
23. The droplet actuator of any of clauses 18 and following, further comprising an arrangement of dispensing electrodes adjacent to or inset into one or more of the central electrodes.
24. The droplet actuator of any of clauses 23 and following, wherein the arrangement of dispensing electrodes is situated in a region of the droplet operations gap having a transition and gap height, wherein the gap height decreases in a direction which is away from the central electrodes.
25. The droplet actuator of any of clauses 23 and following, wherein the arrangement of dispensing electrodes is situated adjacent to a path of droplet operations electrodes, such that the dispensing electrodes are arranged to dispense droplets onto the path of droplet operations electrodes.
26. The droplet actuator of any of clauses 23 and following, wherein the central electrodes are arranged along an X axis, and wherein the length of each central electrode along the X axis is substantially equal to the length of each central electrode's flanking electrodes along the X axis.
27. The droplet actuator of any of clauses 26 and following, wherein the length of each central electrode along a Y axis is substantially greater than the length of each central electrode's flanking electrodes along the Y axis.
28. The droplet actuator of any of clauses 26 and following, wherein the length of each central electrode along a Y axis is at least two times the length of each central electrode's flanking electrodes along the Y axis.
29. The droplet actuator of any of clauses 26 and following, wherein the length of each central electrode along a Y axis is at least three times the length of each central electrode's flanking electrodes along the Y axis.
30. A method of distorting a droplet shaped to effectuate mixing, the method comprising:
   (a) providing the droplet actuator of any of clauses 18 and following;
   (b) activating a central electrode and one or more flanking electrodes which do not flank the activated central electrode.
31. The method of any of clauses 30 and following, comprising activating two or more central electrodes and one or more flanking electrodes which do not flank the activated central electrodes.
32. A droplet actuator comprising:
   (a) one or more substrates arranged to form a droplet operations gap, the droplet operations gap comprising a region of gap height transition in which the gap height of the droplet operations gap transitions from a first gap height to a second gap height;
   (b) electrodes associated with the one or more substrates arranged for conducting droplet operations, the electrodes comprising a transition electrode which traverses the region of gap height transition.
33. The droplet actuator of any of clauses 32 and following, wherein the electrodes comprise electrowetting electrodes.
34. The droplet actuator of any of clauses 32 and following, wherein:
   (a) the transition electrode is flanked by a first set of the electrodes having a first footprint area, and a second set of electrodes having a second footprint area;
   (b) the first footprint area is greater than the second footprint area;
   (c) the first set of electrodes is arranged in a region of greater gap height;
   (d) the second set of electrodes is arranged in the region of lesser gap height.
35. The droplet actuator of any of clauses 32 and following, wherein the transition electrode has a footprint area which is intermediate to the first footprint area and the second footprint area.
36. The droplet actuator of any of clauses 32 and following, wherein the transition electrode comprises an inset electrode, wherein the inset electrode is inset into the transition electrode.
37. The droplet actuator of any of clauses 36 and following, wherein the inset electrode traverses at least a portion of the transition region.
38. The droplet actuator of any of clauses 36 and following, wherein the inset electrode does not transition any portion of the transition region.
39. The droplet actuator of any of clauses 32 and following, comprising multiple transition electrodes associated with a single gap height transition.
40. The droplet actuator of any of clauses 32 and following, comprising multiple transition electrodes associated with multiple gap height transitions.
41. A droplet actuator comprising:
   (a) a droplet operations surface;
   (b) an arrangement of electrodes associated with the droplet operations surface, the electrodes comprising:
      (i) a dispensing electrode having a first footprint area;
      (ii) a path of electrodes having a second footprint area, which is smaller than the first footprint area, wherein at least one electrode of the path of electrodes is inset into the dispensing electrode; and
      (iii) a set of flanking electrodes flanking two or more electrodes of the path of electrodes.
42. The droplet actuator of any of clauses 41 and following, wherein the flanking electrodes flank three or more electrodes of the path of electrodes.
43. The droplet actuator of any of clauses 41 and following, wherein the dispensing electrode is one of an arrangement of two or more dispensing electrodes.
44. The droplet actuator of any of clauses 43 wherein the droplet operations surface is provided in a droplet operations gap and the arrangement of two or more dispensing electrodes is associated with an opening through a substrate forming a fluid path from an exterior locus of the droplet actuator into the droplet operations gap.

## Claims

1. A droplet actuator comprising:
(a) one or more substrates arranged to form a droplet operations gap, the droplet operations gap comprising a region of gap height transition in which the gap height of the droplet operations gap transitions from a first gap height to a second gap height;
(b) electrodes associated with the one or more substrates arranged for conducting droplet operations, the electrodes comprising a transition electrode which traverses the region of gap height transition.

2. The droplet actuator of claim 1, wherein the electrodes comprise electrowetting electrodes.

3. The droplet actuator of claim 1 or claim 2, wherein:
(a) the transition electrode is flanked by a first set of the electrodes having a first footprint area, and a second set of electrodes having a second footprint area;
(b) the first footprint area is greater than the second footprint area;
(c) the first set of electrodes is arranged in a region of greater gap height;
(d) the second set of electrodes is arranged in the region of lesser gap height.

4. The droplet actuator of any preceding claim, wherein the transition electrode has a footprint area which is intermediate to the first footprint area and the second footprint area.

5. The droplet actuator of any preceding claim, wherein the transition electrode comprises an inset electrode, wherein the inset electrode is inset into the transition electrode.

6. The droplet actuator of claim 5, wherein the inset electrode traverses at least a portion of the transition region.

7. The droplet actuator of claim 5 or claim 6, wherein the inset electrode does not transition any portion of the transition region.

8. The droplet actuator of any preceding claim, comprising multiple transition electrodes associated with a single gap height transition.

9. The droplet actuator of any preceding claim, comprising multiple transition electrodes associated with multiple gap height transitions.
